# EUROPEAN PATENT APPLICATION

(11) **EP 3 240 164 A1**
(43) Date of publication of application: **01.11.2017**
(21) Application number: 15872918.6
(22) Date of filing: 18.12.2015
(51) Int. Cl.: H02K 33/16

(54) **ACTUATOR**

(30) Priority: 26.12.2014 JP 2014263861; 13.05.2015 JP 2015098104
(71) Applicant: Nidec Sankyo Corporation, Nagano-ken 393-8511 (JP)
(72) Inventor: TAKEDA, Tadashi, Nagano 393-8511 (JP); SUE, Takeshi, Nagano 393-8511 (JP); TSUCHIHASHI, Masao, Nagano 393-8511 (JP); KITAHARA, Hiroshi, Nagano 393-8511 (JP)
(74) Representative: Becker Kurig Straus
(86) International application number: PCT/JP2015/085464
(87) International publication number: WO 2016/104349

(57) **Abstract**

The present application is to propose an actuator capable of causing vibrations in multiple directions to a movable body. For example, the actuator 1 has the supporting body 5, the movable body 4, and the connecting body 7 which is connected to the movable body 4 and the supporting body 5. Between the supporting body 5 and the movable body 4, the first magnetic driving circuit 10 is configured by the first magnets 11 and the first coil 12 opposed to the first magnets 11 in the first direction L1 to generate the driving force to drive the movable body 4 in the second direction L2, which perpendicularly intersects with the first direction L1, with respect to the supporting body 5. Between the supporting body 5 and the movable body 4, the second magnetic driving circuit 20 is also configured by the second magnets 21 and the second coil 22 opposed to the second magnets 21 in the first direction L1 to generate the driving force to drive the movable body 4 in the third direction L3 which perpendicularly intersects with the first direction L1.

## Description

### BACKGROUND OF THE INVENTION

### 1. Field of the Invention

The present invention relates to an actuator equipped with a magnetic driving mechanism.

### 2. Description of Related Art

Proposed for an actuator which allows a user to feel vibrations is a structure with a magnetic driving mechanism which is provided with cylindrical coils and cylindrical magnets around a movable body to oscillate the movable body in the axial direction (Patent references 1 and 2).

### [Prior Art Reference]

[Patent reference 1] Unexamined Japanese Patent Application 2002-78310 Publication.
[Patent reference 2] Unexamined Japanese Patent Application 2006-7161 Publication.

### SUMMARY OF THE INVENTION

In the structure disclosed in Patent references 1 and 2, however, a movable body vibrates only in the axial direction; therefore, this structure allows a user to feel only one type of vibration. For this reason, when transmitting data to a user through vibrations, only small amount of data is transmitted to the user.

Taking the above problem into consideration, an objective of the present invention is to provide an actuator capable of making a movable body oscillate in multiple directions.

To achieve the above objective, an actuator of the present invention has a supporting body, a movable body, a connecting body which is connected to the movable body and the supporting body and provided with elasticity or viscoelasticity, a first magnetic driving circuit which is provided with first magnets held by the supporting body or the movable body and a first coil held by the other and opposed to the first magnets in the first direction to generate a driving force to drive the movable body in the second direction which perpendicularly intersects with the first direction, and a second magnetic driving circuit provided with second magnets, which are held by the supporting body or the movable body, and a second coil, which are held by the other and opposed to the second magnets in the first direction to generate a driving force to drive the movable body in a third direction which intersects perpendicularly with the first direction and intersects with the second direction.

In the present invention, the movable body is supported by the supporting body through the connecting body having at least either elasticity or viscoelasticity; provided between the movable body and the supporting body are the first magnetic driving circuit which generates a driving force to drive the moving body in the second direction with the first coil and the first magnets which are opposed to one another in the first direction and the second magnetic driving circuit which generates a driving force to drive the moving body in the third direction with the second coil and the second magnets which are opposed to one another in the first direction. Thus, the movable body can be oscillated in the second direction and in the third direction; therefore, a user can feel the vibrations in the second direction and in the third direction. Also, the coil and the magnets are opposed to one another in the first direction in both the first magnetic driving circuit and second magnetic driving circuit; therefore, even when the first magnetic driving circuits and the second magnetic driving circuits are provided [in the actuator], the size of the actuator in the first direction can be minimized.

In the present invention, it is preferred that, when viewed from the directions perpendicular to the first direction, the first magnetic driving circuit and the second magnetic driving circuit be arranged at the same positions in the first direction. With this configuration, even when the first magnetic driving circuit and the second driving circuit are provided [in the actuator], the size of the actuator in the first direction can be minimized.

In the present invention, it is preferred that the second direction and the third direction intersect perpendicularly with one another. With this configuration, a user can distinguish the vibrations caused when the movable body is oscillated in the second direction from the vibrations caused when the movable body is oscillated in the third direction.

In the present invention, a configuration can be adopted, in which the first magnetic driving circuit is arranged at two positions which are separated in the second direction and overlap with one another when viewed from the second direction and the second magnetic driving circuit is arranged at two locations which are separated in the third direction and overlap with one another when viewed from the third direction.

In the present invention, a configuration can be adopted, in which the first magnetic driving circuit is arranged at two positions which are separated in the third direction and overlap with one another when viewed from the third direction and the second magnetic driving circuit is arranged at two positions which are separated in the second direction and overlap with one another when viewed from the second direction.

In the present invention, a configuration can be adopted, in which the first magnetic driving circuit is arranged at two positions which are separated in the second direction and are shifted from one another in the third direction when viewed from the second direction and the second magnetic driving circuit is arranged at two positions which are separated in the third direction and are shifted in the second direction when viewed from the third direction.

In the present invention, it is preferred that the first magnetic driving circuit and the second magnetic driving circuit be arranged to appear alternately around the center of gravity of the movable body when viewed from the first direction. With this configuration, when oscillated in the second direction or in the third direction, the movable body can be prevented from rotating. Also, the movable body can be oscillated around the center of gravity.

In the present invention, it is preferred that both the first magnetic driving circuits arranged at two positions be point symmetry turned about the center of gravity and the second magnetic driving circuits at two positions be point symmetry turned about the center of gravity when viewed from the first direction. With this configuration, when the movable body is oscillated in the second direction or in the third direction, the movable body can be prevented from rotating. Also, the movable body can be oscillated around the center of gravity.

In the present invention, a configuration can be adopted, in which the first magnetic driving circuits arranged at the two positions are line symmetry reflected over an imaginary line that passes the center of gravity and extends in the third direction when viewed from the first direction and the second magnetic circuits arranged at the two positions are line symmetry reflected over an imaginary line that passes the center of gravity and extends in the second direction [when viewed from the first direction]. With this configuration, when oscillated in the second direction or in the third direction, the movable body can be kept from rotating.

In the present invention, a configuration may be adopted, in which the first magnetic driving circuit and the second magnetic driving circuit overlap with one another by at least a portion thereof when viewed from the first direction. With this configuration, the size of the actuator viewed from the first direction can be minimized.

In the present invention, a configuration may be adopted, in which a third magnetic driving circuit is further provided with first magnets held by the supporting body or the movable body and a third coil held by the other and opposed to the third magnets in the first direction to generate a driving force to drive the movable body in a fourth direction which intersects perpendicularly with the first direction and intersects diagonally with the second direction and the third direction. With this configuration, the movable body can be oscillated in the second direction, in the third direction and in the fourth direction, and also the movable body can do synthesized oscillations of the second direction, the third direction and the fourth direction.

In this case, a configuration may be adopted, in which the second direction and the third direction intersect with one another diagonally.

In the present invention, it is preferred that at least a gel damper member be used for the connecting body. With this configuration, the movable body is prevented from resonating.

In the present invention, it is preferred that only the gel damper member be used for the connecting body. With this configuration, the connecting body does not have a spring component; therefore, the movable body can be prevented from resonating, and the support structure of the supporting body for the movable body can be simplified.

In the present invention, it is preferred that the gel damper member be fixed to both the movable body and the supporting body. With this configuration, even when the movable body moves in the direction away from the supporting body at the position at which the gel damper member is arranged, the gel damper member deforms following such a move to effectively prevent the movable body from resonating.

In the present invention, a configuration can be adopted in which the gel damper member be made of silicone gel, for example.

In the present invention, it is preferred that the supporting body be provided with a first movement-regulating portion which regulates the moving range of the movable body in the second direction or a second movement-regulating portion which regulates the moving range of the movable body in the third direction, or be provided with both. With this configuration, the moving range of the movable body can be limited to the range within which the deformation amount of the connecting body does not exceed the ultimate deformation amount. In this way, the connecting body can be prevented from being broken.

In the present invention, it is preferred that the movable body be configured by joining a first holding member which holds the first magnets with a second holding member which holds the second magnets, and that the first movement-restricting member and the second movement-restricting member abut on the movable body at the positions different from the joining portion of the first holding member and the second holding member. With this configuration, the joining portion of the movable body which is weak in strength will not collide the first movement-restricting portion or the second movement-restricting portion. Therefore, the chance of the movable body being broken due to shock is lessened.

In the present invention, it is preferred that, when the movable body moves relative to the supporting body in the second direction and in the third direction, the connecting body deforms in the direction perpendicular to the stretching direction of the connecting body, according to the deformation characteristic of the shear direction in which nonlinear component is greater (more) than linear component. With this configuration, an oscillation characteristic having an excellent linearity can be obtained.

In the present invention, it is preferred that the connecting body connect the movable body and the supporting body in the first direction at the position at which the movable body and the supporting body are opposed to each other in the first direction, and that when the movable body approaches the supporting body in the first direction, the connecting body be compressed according to the stretching characteristic in which the non-linear component is greater (more) than the linear component. With this configuration, it can be avoided that the gap between the movable body and the supporting body in the first direction changes significantly, maintaining the gap between the movable body and the supporting body in the first direction.

### [Effects of the Invention]

In the present invention, the movable body can be oscillated in the second and third directions; therefore, a user can feel the vibrations in the second direction as well as the vibrations in the third direction. Also, in both the first magnetic driving circuit and the second magnetic driving circuit, the coil and the magnets are opposed to one another in the first direction; therefore, even when the first magnetic driving circuit and the second magnetic driving circuit are provided, the size of the actuator in the first direction can be minimized.

### BRIEF DESCRIPTION OF THE DRAWINGS

Fig. 1 is an explanatory diagram of an actuator of Embodiment 1 of the present invention.
Fig. 2 is an exploded perspective view of the actuator of Embodiment 1 of the present invention.
Fig. 3 is an explanatory diagram of a magnetic driving circuit of the actuator of Embodiment 1 of the present invention.
Fig. 4 is an explanatory diagram of a planar layout of the magnetic driving circuits of the actuator of Embodiment 1 of the present invention.
Fig. 5 is an explanatory diagram of an actuator of Embodiment 2 of the present invention.
Fig. 6 is an exploded perspective view of the actuator of Embodiment 2 of the present invention.
Fig. 7 is an explanatory diagram of a planar layout of magnetic driving circuit of an actuator of Embodiment 3 of the present invention.
Fig. 8 is an explanatory diagram of a planar layout of magnetic driving circuits of an actuator of Embodiment 4 of the present invention.
Fig. 9 is an explanatory diagram of a planar layout of magnetic driving circuits of an actuator of Embodiment 5 of the present invention.
Fig. 10 is an explanatory diagram of magnetic driving circuits of an actuator of Embodiment 6 of the present invention.
Fig. 11 is an explanatory diagram of magnetic driving circuits of an actuator of Embodiment 7 of the present invention.
Fig. 12 is an explanatory diagram of magnetic driving circuits of an actuator of Embodiment 8 of the present invention.
Fig. 13 is an explanatory diagram of an actuator of Embodiment 9 of the present invention.
Fig. 14 is an exploded perspective view of the actuator of Embodiment 9 of the present invention.
Fig. 15 is an exploded perspective view of a major portion of the actuator of Embodiment 9 of the present invention.
Fig. 16 is a plan view of the actuator, from which a second case is removed, of Embodiment 9 of the present invention.

### DESCRIPTION OF THE EMBODIMENTS

Embodiments of the present invention are described referring to the drawings. Note that, for the purpose of clarifying a layout, etc. of magnetic driving circuits in the description below, an X-axis direction, a Y-axis direction and a Z-axis direction are the directions which intersect with one another perpendicularly; one side of the X-axis direction is X1, the other side of the X-axis direction is X2, one side of the Y-axis direction is Y1, the other side of the Y-axis direction is Y2, one side of the Z-axis direction is Z1 and the other side of the Z-axis direction is Z2. Of the directions in which the driving force is generated by the magnetic driving circuits, the first direction is L1, the second direction is L2 and the third direction is L3.

### [Embodiment 1]

### (Overall configuration)

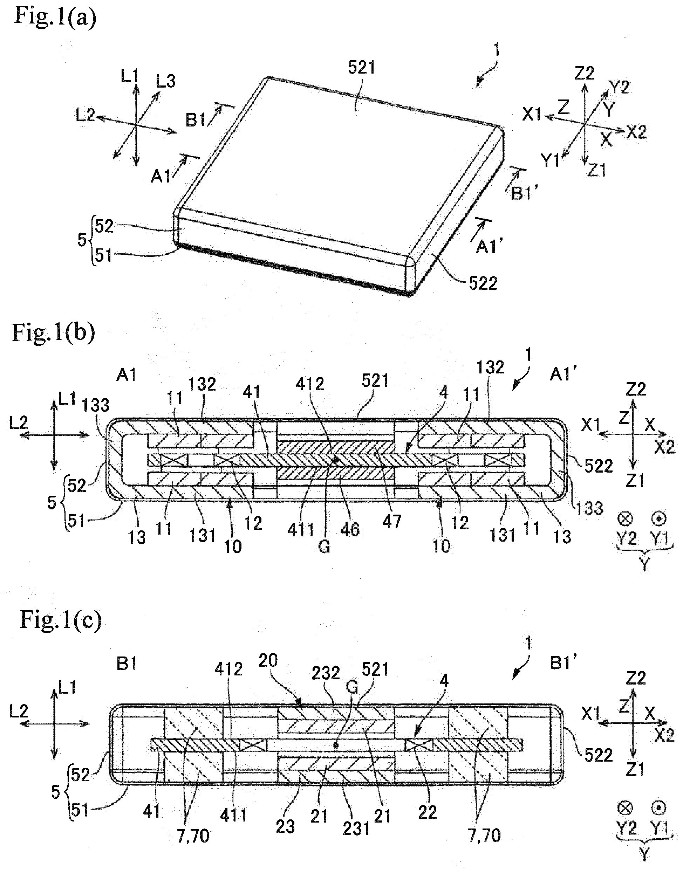

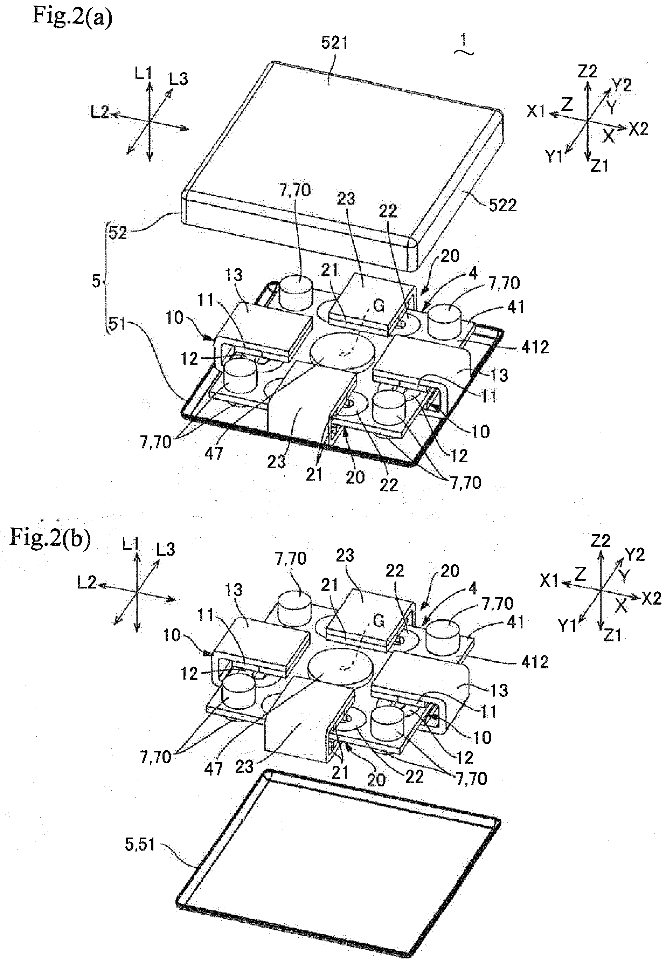

Fig. 1 is an explanatory diagram of an actuator 1 of Embodiment 1 of the present invention: Fig. 1 (a), (b) and (c) are respectively a perspective view of the actuator 1, an XZ cross-sectional view when the actuator 1 is sectioned along an A1-A1' line passing the center portion of the actuator 1, and an XZ cross-sectional view when the actuator 1 is sectioned along a B1-B1' line passing through the edge portion of the actuator 1. Fig. 2 is an exploded perspective view of the actuator 1 of Embodiment 1 of the present invention: Fig. 2 (a) and (b) are respectively an exploded perspective view [of the actuator 1] in which a second case 52 is removed and an exploded perspective view [of the actuator 1] in which a movable body is separated from the first case 51.

In Fig. 1 and Fig. 2, the actuator 1 of the present invention is an oscillation actuator which allows a user to feel vibrations. The actuator 1 has a supporting body 5, a movable body 4, and a connecting body 7 connected to the movable body 4 and the supporting body 5; the movable body 4 is supported to the supporting body 5 via the connecting body 7. The connecting body 7 has at least elasticity or viscoelasticity. The actuator 1 also has a first magnetic driving circuit 10 and a second magnetic driving circuit 20 which causes the movable body 4 relative movements with respect to the supporting body 5.

In this embodiment, the supporting body 5 includes a first case 51 positioned on one side Z1 of the Z-axis direction and a second case 52 which covers the first case 51 from the other side Z2 of the Z-axis direction. The first case 51 is composed of a plate-like member which is quadrangle when viewed in the Z-axis direction, and the second case 52 is composed of a box-like member which is quadrangle when viewed in the Z-axis direction. The second case 52 includes an end plate portion 521 opposed to the first case 51 and a square cylindrical body portion 522 protruding from the edge of the end plate portion 521 toward the first case 51; the end portion of the body portion 522 on one side Z1 of the Z-axis direction is connected to the first case 51.

The movable body 4 has a plate-like member 41 in which the thickness direction thereof is the Z-axis direction, and the plate-like member 41 is formed in a square planar shape smaller than the supporting body 5 when viewed from the Z-axis direction. Also, the movable body 4 is equipped with a first flat weight member 46 secured in the center of a first surface 411 facing one side Z1 of the Z-axis direction of the plate-like member 41 and a second flat weight member 47 secured in the center of a second surface 412 facing the other side Z2 of the Z-axis direction of the plate-like member 41. In this embodiment, the first weight member 46 and the second weight member 47 are composed of a metallic plate which is circular when viewed from the Z-axis direction.

### (Configuration of Connecting Body 7)

In this embodiment, the connecting body 7 is composed of a gel damper member 70 provided around four corners of the plate-like member 41 of the movable body 4; the gel damper member 70 are arranged at four positions between the plate-like member 41 and the first case 51 and at four positions between the plate-like member 41 and the end plate portion 521 of the second case 52. Therefore, the gel damper members 70 are arranged so as to surround the center of gravity G of the movable body 4 including first coils 12 and second coils 22 which are described later. Also, the gel damper members 70 arranged at eight positions are respectively connected to the movable body 4 and the supporting body 5. More specifically described, of the gel damper members 70 arranged at eight positions, the gel damper members 70 arranged between the plate-like member 41 and the first case 51 are connected to the plate-like member 41 and the first case 51 having each end surfaces thereof in the Z-axis direction connected by an adhesive of the like. Also, the gel damper members 70 arranged between the plate-like member 41 and the end plate portion 521 of the second case 52 are connected to the plate-like member 41 and the second case 52 having each end surfaces thereof in the Z-axis direction connected by an adhesive or the like.

The gel damper member 70 has viscoelasticity and also has linear or non-linear stretching characteristics, depending on the stretching direction. For example, when pressed in the thickness direction (the axial direction) for compressive deformation, the plate-like gel damper members 70 demonstrate the stretching characteristics in which the non-linear component is greater (more) than the linear component. On the other hand, when stretched by being pulled in the thickness direction (the axial direction), the damper members 70 demonstrate the stretching characteristics in which the linear component is greater (more) than the non-linear component. Even when deformed in the direction (the shear direction) which intersects with the thickness direction (the axial direction), the damper members 70 demonstrate the deformation characteristics in which the linear components is greater (more) than the non-linear component. In this embodiment, the gel damper member 70 is composed of silicone gel shaped in a cylindrical form, and has a penetration from 90° to 110°. As defined in JIS-K-2207 or JIS-K-2220, the penetration is measured as the penetration depth of a 1/4 scale cone needle, which weighs 9.3g , penetrating per 5 seconds at 25°C is expressed in 1/10 millimeters: the smaller the value is, the harder the silicone is.

In the actuator 1 of this embodiment, the first magnetic driving circuit 10 and the second magnetic driving circuit 20 which generate the driving force to drive the movable body 4 in two directions intersecting with each other are arranged between the supporting body 5 and the movable body 4; the first magnetic driving circuit 10 and the second magnetic driving circuit 20 are respectively provided with magnets held by the supporting body 5 or the movable body 4 and a coil held by the other. More specifically, the first magnetic driving circuit 10 is provided with the first magnets 11 held by the supporting body 5 and the first coil 12 held by the movable body 4; the first magnets 11 and the first coil 12 are opposed to each other in the first direction L1 and generate the driving force to drive the movable body 4 in the second direction L2 which intersects perpendicularly with the first direction L when the first coil 12 is electrified. The second magnetic driving circuit 20 is provided with second magnets 21 held by the supporting body 5 and a second coil 22 held by the movable body 4 and generate the driving force to drive the movable body 4 in the third direction which perpendicularly intersects with the first direction L1 and intersects with the second direction L2. In this embodiment, the first direction L1 is parallel to the Z-axis direction; the second direction L2 is parallel to the X-axis direction; the third direction L3 is parallel to the Y-axis direction. Therefore, the second direction L2 and the third direction L3 perpendicularly intersect with each other.

### (Detailed Description of Magnetic Driving Circuit)

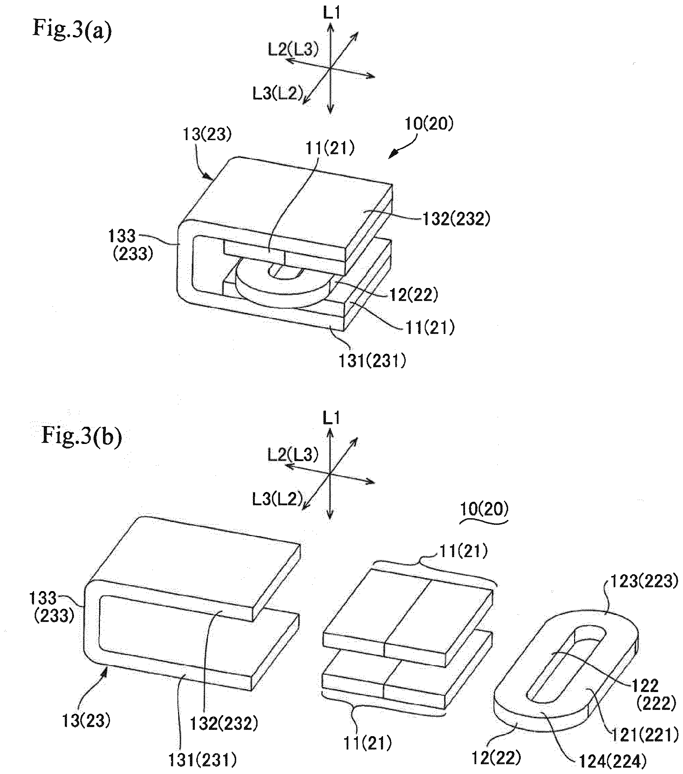

Fig. 3 is an explanatory diagram of the magnetic driving circuit of the actuator 1 of Embodiment 1 of the present invention. Fig. 3 (a) and (b) are respectively a perspective view of the magnetic driving circuit and an exploded perspective view of the same.

In this embodiment, the first magnetic driving circuit 10 and the second magnetic driving circuit 20 respectively have the configuration shown in Fig. 3. In this embodiment, the first magnetic driving circuit 10 and the second magnetic driving circuit 20 share the same basic configuration; therefore, Fig. 3 illustrates the configuration of the first magnetic driving circuit 10 and the configuration of the second magnetic driving circuit 20 is indicated in parenthesis.

As shown in Fig. 1 (a) and (b), Fig. 2 and Fig. 3, the first magnetic driving circuit 10 has the first magnets 11 held to the supporting body 5 and the first coil to the movable body 4 which are opposed to each other in the first direction L1 (the Z-axis direction). In this embodiment, the first magnet 11 is arranged at two positions, one at which it is opposed to the first coil 12 on one side Z1 of the Z-axis direction and the other at which it is opposed to the first coil 12 on the other side Z2 of the Z-axis direction; the two first magnets 11 are respectively held to the supporting body 5. More specifically, of the two first magnets 11, the first magnet 11 which is opposed to the first coil 12 on one side Z1 of the Z-axis direction is held to the first case 51, and the first magnet 11 which is opposed to the first coil 12 on the other side Z2 of the Z-axis direction is held to the end plate portion 521 of the second case 52.

The first coil 12 is a flat air core inductor which has two longitudinal sides 121 and 122 extending in the third direction L3 and two short sides 123 and 124 extending in the second direction L2; the two longitudinal sides 121 and 122 are opposed to each other in the second direction L2 and the two short sides 123 and 124 are opposed to each other in the third direction L3. The first magnet 11 is a plate-like permanent magnet which is magnetized with S-pole and N-pole in the second direction L2, and is opposed to the longitudinal sides 121 and 122 of the first coil 12. Therefore, the longitudinal sides 121 and 122 of the first coil 12 are used as the significant sides; when the first coil 12 is electrified, the driving force is generated to drive the movable body 4 in the second direction L2 (the X-axis direction).

The first magnetic driving circuit 10 has a yoke 131, which overlaps the first magnet 11 on one side Z1 of the Z-axis direction from the side opposite the first coil 12, and a yoke 132, which overlaps the first magnet 11 on the other side Z2 of the Z-axis direction from the side opposite the first coil 12; the two first magnets 11 are respectively supported by the supporting body 5 via the yoke 131, 132. More specifically described, as shown in Fig. 1 (b), the first magnet 11 on one side Z1 of the Z-axis direction is secured to the first case 51 via the yoke 131, and the first magnet 11 on the other side Z2 of the Z-axis direction is secured to the end plate portion of the second case 52 via the yoke 132. In this embodiment, the two yokes 131 and 132 are composed of a first magnetic substance 13 which is a single unit having a connecting portion 133 bent in the U-shape to connect the yoke portions; the connecting portion 133 is secured to the inner surface of the body portion 522 of the second case 52.

As shown by parentheses in Fig. 3, the second magnetic driving circuit 20 has second magnets 21 held to the supporting body 5 and a second coil 22 held to the movable body 4, and the second magnets 21 and the second coil 22 are opposed to each other in the first direction L1 in the same manner as the first magnetic driving circuit 10. In this embodiment, the second magnet 21 is arranged at two positions, one at which it is opposed to the second coil 22 on one side Z1 of the Z-axis direction and the other at which it is opposed to the second coil 22 on the other side Z2 of the Z-axis direction; the two second magnets 21 are respectively supported by the supporting body 5.

The second coil 22 is a flat air core inductor which has two longitudinal sides 221 and 222 extending in the second direction L2 and two short sides 223 and 224 extending in the third direction L3; the two longitudinal sides 221 and 222 are opposed to each other in the third direction L3 and the two short sides223 and 224 are opposed to each other in the second direction L2. The second magnet 21 is plate-like a permanent magnet which is magnetized with S-pole and N-pole in the third direction L3 and are opposed to the longitudinal sides 221 and 222 of the first coil 22. Therefore, the longitudinal sides 221 and 222 of the second coil 22are used as the significant sides; when the second coil 22 is electrified, the driving force is generated to drive the movable body 4 in the third direction L3 (the Y-axis direction).

Also, the second magnetic driving circuit 20 has a yoke 231, which overlaps the second magnet 21 on one side Z1 of the Z-axis direction from the side opposite the second coil 22, and a yoke 232, which overlaps the second magnet 21 on the other side Z2 of the Z-axis direction, from the side opposite the second coil 22; the two second magnets 21 are respectively supported to the supporting body 5 via the yoke 231, 232. More specifically described, as shown in Fig. 1 (c), the second magnet 21 on one side Z1 of the Z-axis direction is secured to the first case 51 via the yoke 231, and the second magnet 21 on the other side Z2 of the Z-axis direction is secured to the end plate portion 521 of the second case 52 via the yoke 232. In this embodiment, the two yokes 231 and 232 are configured by a second magnetic substance 23 which is a single unit having a connecting portion 233, which is bent in the U-shape, to connect the yoke portions; the connecting portion 233 is secured to the inside surface of the body portion 522 of the second case 52.

In the actuator 1 configured as above, the first magnetic driving circuit 10 and the second magnetic driving circuit 20 are arranged to appear at the same height positions in the first direction L1 when viewed from the direction which perpendicularly intersects with the first direction L1.

### (Planar Layout of Magnetic Driving Circuit)

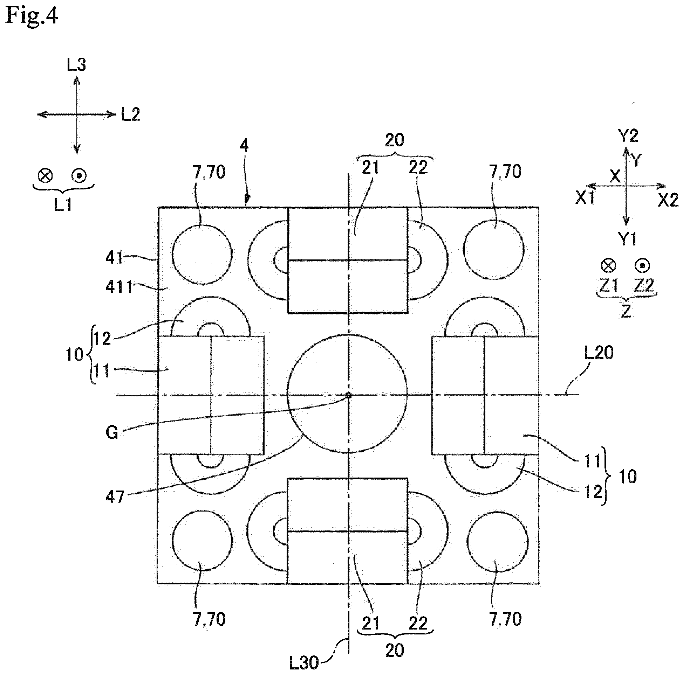

Fig. 4 is an explanatory diagram showing a planar layout of the magnetic driving circuits in the actuator of Embodiment 1 of the present invention. Note that one coil and only one magnet, out of multiple members that configure the first magnetic driving circuit 10 or the second magnetic driving circuit 20, are illustrated in Fig. 4.

As shown in Fig. 4, in the actuator 1 of this embodiment, when viewed in the first direction L1, the movable body 4 is quadrangle, the first magnetic driving circuits 10 are respectively arranged in the centers of the two sides of the movable body 4, which are opposed to one another in the second direction L2, and the second magnetic driving circuits 20 are respectively arranged in the centers of the two sides of the movable body 4, which are opposed to one another in the third direction L3. Therefore, the first magnetic driving circuits 10 are apart from one another in the second direction L2 and arranged at two positions which appear to overlap when viewed from the second direction L2. Also, the second magnetic driving circuits 20 are separated in the third direction L3 and arranged at two positions which appear to overlap when viewed in the third direction L3.

When viewed from the first direction L1, the first magnetic driving circuits 10 and the second magnetic driving circuits 20 are alternately arranged around the center of gravity G of the movable body 4. Also, when viewed from the first direction L1, the first magnetic driving circuits 10 at the two positions are arranged to be point symmetry turned about the center of gravity G of the movable body 4, and the second magnetic driving circuits 20 at the two positions are arranged to be point symmetry turned about the center of gravity G of the movable body 4. Also, when viewed from the first direction L1, the first magnetic driving circuits 10 at the two positions are arranged to be line symmetry reflected over an imaginary line L30, which passes through the center of gravity G of the movable body 4 and extends in the third direction L3, and the second magnetic driving circuits 20 at the two positions are arranged to be line symmetry reflected over the imaginary line L30, which passes through the center of gravity G of the movable body 4 and extends in the second direction L2.

In this embodiment, also, when viewed from the first direction L1, the movable body 4 appears to be square. Therefore, when viewed from the first direction L1, the first magnetic driving circuits 10 and the second magnetic driving circuits 20 are at equal angle intervals around the center of gravity G of the movable body 4.

### (Operation)

In the actuator 1 of this embodiment, for example, while an alternating current is applied to the first coil 12 of each of the first magnetic driving circuits 10, a current supply is halted to the second coil 22 of each of the second magnetic driving circuits 20. Consequently, the movable body 4 oscillates in the second direction L2; therefore, the center of gravity of the actuator 1 changes in the second direction L2. Therefore, a user can feel the vibrations in the second direction L2. At that time, if an AC waveform applied to the first coil 12 is adjusted and the speed at which the movable body 4 moves to one side of the second direction L2 is distiguished from the speed at which the movable body 4 moves to the other side of the second direction L2, the user can feel vibrations that have directionality in the second direction L2.

In the same manner, an alternating current is applied to the second coil 22 of each of the second magnetic driving circuits 20, the current supply is halted to the first coil 12 of each of the first magnetic driving circuits 10. Consequently, the movable body 4 oscillates in the third direction L3; accordingly, the center of graving of the actuator 1 changes in the third direction L3. Therefore, a user can feel vibrations in the third direction L3. At that time, if the AC waveform applied to the second coils 22 is adjusted and the speed at which the movable body 4 moves to one side of the third direction L3 is distinguished from the speed at which the movable body 4 moves to the other side of the third direction L3, the user can feel vibrations that have directionality in the third direction L3.

Also, if electrification to the first coils 12 and electrification to the second coils 22 are combined, a user can have an experience of feeling the combined vibrations in the second direction L2 and in the third direction L3.

### (Major Effects of This Embodiment)

As described above, in the actuator 1 of this embodiment, the movable body 4 is supported to the supporting body 5 by the connecting body 7; provided between the movable body 4 and the supporting body 5 are the first magnetic driving circuit 10, which generates the driving force to drive [the movable body 4] in the second direction L2 perpendicularly intersecting with the first direction L1 with the coil and the magnets opposed in the first direction L1, and the second magnetic driving circuit 20, which generates the driving force to drive the movable body 4 in the third direction L3 intersecting with the second direction L2 with the coil and the magnets opposed in the first direction L1. For this reason, the movable body 4 can be oscillated in the second direction L2 and also in the third direction L3. Therefore, a user can feel the vibrations in the second direction L2 and in the third direction L3. Since the coil and the magnets are opposed in the first direction L1 in the first magnetic driving circuit 10 or the second magnetic driving circuit 20, the size of the actuator 1 in the first direction L1 can be made small although the first magnetic driving circuit 10 and the second magnetic driving circuit 20 are provided.

In this embodiment, the second direction L2 and the third direction L3 intersect with each other perpendicularly; therefore, the vibrations a user feels when the movable body 4 is oscillated in the second direction L2 can be distinguished from the vibration the user feels when the movable body 4 is oscillated in the third direction L3.

Also, the first magnetic driving circuit 10 is provided at two positions which are separated in the first direction L2, and the second magnetic driving circuit 20 is provided at two positions which are separated in the third direction L3. Therefore, the power to oscillate the movable body 4 be can be increased.

The first magnetic driving circuits 10 and the second magnetic driving circuits 20 are alternately arranged around the center of gravity G of the movable body 4. Also, the first magnetic driving circuit 10 is arranged at two positions which are separated from each other in the second direction L2 and overlap when viewed from the second direction L2. Also, the second magnetic driving circuit 20 is arranged at two positions which are separated from each other in the third direction L3 and overlap when viewed from the third direction L3. For this reason, when the first magnetic driving circuits 10 and the second magnetic driving circuits 20 are driven to oscillate the movable body 4 in the second direction L2 and in the third direction L3, the movable body 4 does not easily rotate around the axial line which extends in the first direction L1; therefore, the movable body 4 can be efficiently oscillated.

In this embodiment, particularly, the first magnetic driving circuits 10 at two positions are arranged to be point symmetry turned about the center of gravity G of the movable body 4, and the second magnetic driving circuits 20 at two positions are also arranged to be point symmetry turned about the center of gravity G of the movable body 4. Also, the first magnetic driving circuits 10 at two positions are arranged to be line symmetry reflected over the imaginary line L30 which passes through the center of gravity G of the movable body 4 and extends in the third direction L3 when viewed from the first direction L1; in the same manner, the second magnetic driving circuits 20 at two positions are arranged to be line symmetry reflected over the imaginary line L20, which passes through the center of gravity G of the movable body 4 and extends in the second direction L2, when viewed from the first direction L1. For this reason, when the first magnetic driving circuits 10 and the second magnetic driving circuits 20 are driven to oscillate the movable body 4 in the second direction L2 and in the third direction L3, the movable body 4 rotates even less easily around the axial line extending in the first direction L1; therefore, the movable body 4 can be oscillated even more efficiently.

In the actuator 1, when the connecting body 7 for connecting the movable body 4 and the supporting body 5 is composed of a spring member, the movable body 4 sometimes resonates at the frequency corresponding to the mass of the movable body 4 and the spring constant of the spring member; however, in this embodiment, the gel damper member 70 is used for the connecting body 7. In this embodiment, also, only the gel damper member 70 is used for the connecting body 7; the gel-damper member 70 has no spring components or has a deformation property which has no spring components or has fewer spring components depending on its deformation direction. For this reason, resonance of the movable body 4 can be prevented. Also, the gel damper members 70 are secured to both the movable body 4 and the supporting body 5 by a method of adhesive, etc. Therefore, the gel damper members 70 are kept from moving with the movement of the movable body 4. Since only the gel damper member 70 can be used for the connecting body 7, the configuration of the actuator 1 can be simplified. Also, the gel damper member 70 has its penetration at from 90 degrees to 100 degrees. Therefore, the gel damper member 70 has elasticity sufficient enough to demonstrate damper function, and will rarely be broken and scattered.

The gel damper member 70 is arranged at both ends of the movable body 4 in the first direction L1 between the supporting body 5 and the movable body 4. Therefore, when the movable body 4 oscillates in the first direction L1, the gel damper member 70 is given a compressive deformation on either one or the other side of the first direction L1 and is given a stretch in its thickness direction (the axial direction) on other side. As described above, the gel damper member 70 has the stretching property in which the nonlinear components is more than the linear component at the time of compression; therefore, when the movable body 4 moves in the first direction L1, the gel damper member 70 on the compression side is always compressed according to the non-linear stretching property. Therefore, significant changes in the gap between the movable body 4 and the supporting body 5 are avoided, and therefore, the gap between the movable body 4 and the supporting body 5 in the first direction can be maintained.

Also, when the movable body 4 moves in the second direction L2 and in the third direction L3, the gel damper member 70 deforms in the direction (the shear direction) perpendicularly intersecting with the thickness direction (the axial direction). In other words, the shear direction of the gel damper member 70 is, when the gel damper member 70 connecting the supporting body 5 and the movable body 4 which are opposed to each other in the first direction L1 stretches, the direction perpendicularly intersecting with its stretching direction, which is the direction parallel to the oscillation direction of the movable body 4. Therefore, for oscillating the movable body 4 in the second direction L2 and the third direction L3, the actuator 1 uses the deformation property of the shear direction of the gel damper member 70. The deformation property of the shear direction of the gel damper member 70 has more linear components than the non-linear components. Therefore, the vibration property of good linearity can be obtained in the driving direction (the second direction L2, the third direction L3) of the actuator 1.

### [Embodiment 2]

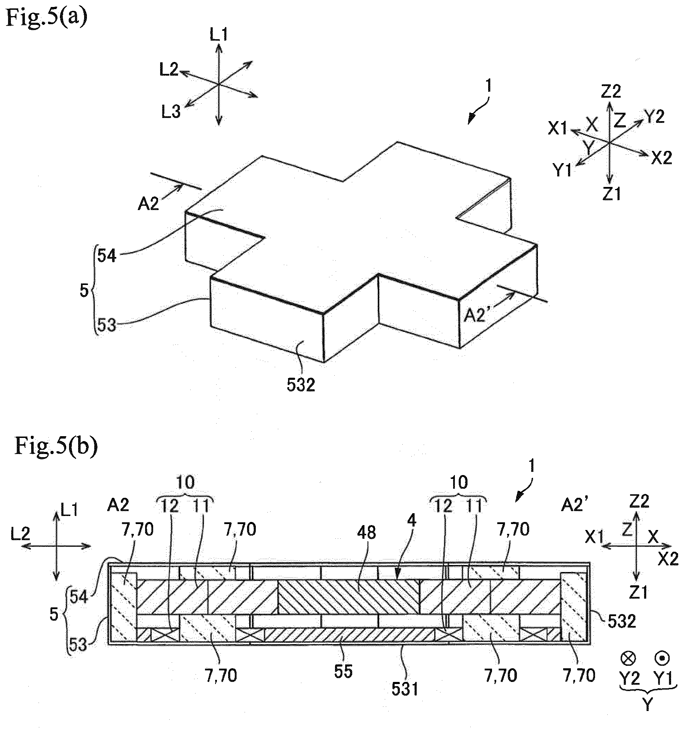

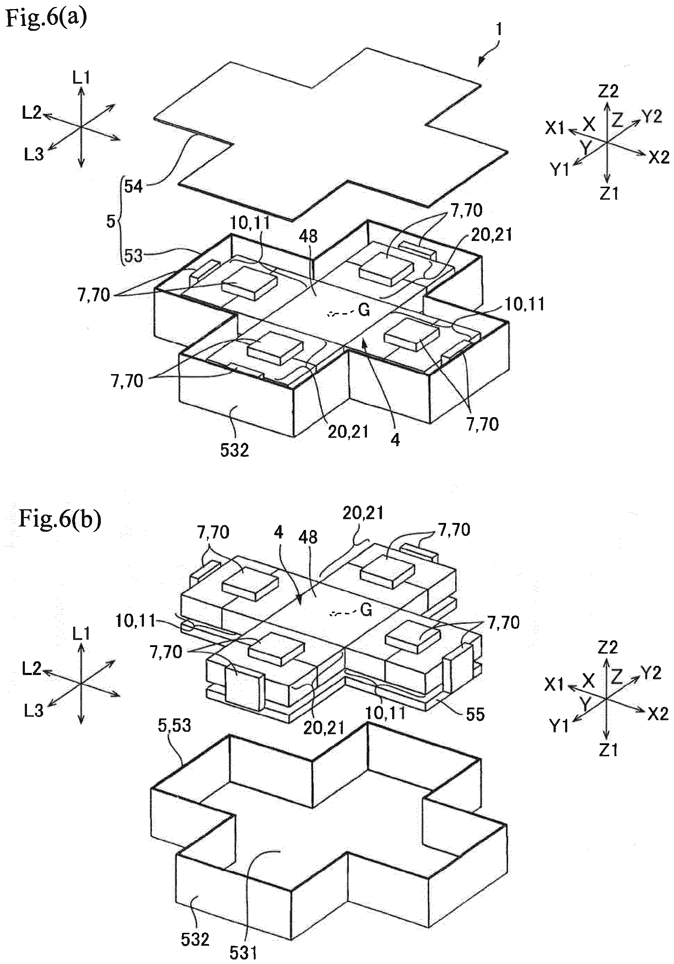

Fig. 5 is an explanatory diagram of an actuator 1 of Embodiment 2 of the present invention: Fig. 5 (a) and (b) are respectively a perspective view of the actuator 1 and an X-Y cross-sectional view of the actuator 1 when sectioned along an A2-A2' line, which passes through the center portion of the actuator 1. Fig. 6 is an exploded perspective view of the actuator 1 of Embodiment 2 of the present invention: Fig. 6 (a) and (b) are respectively an exploded perspective view of the actuator having the second case 54 removed and an exploded perspective view of the actuator having the movable body 4, etc. separated from the first case 53. Note that, since the basic configuration of this embodiment is the same as Embodiment 1, the same codes are given to the corresponding portions and their descriptions are omitted.

In Embodiment 1, the coils are held to the movable body 4 and the magnets are held to the supporting body 5; however, in this embodiment, the coils are held to the supporting body 5 and the magnetic are held to the movable body 4. More specifically described, as shown in Fig. 5 and Fig. 6, the actuator 1 of this embodiment is also an oscillation actuator that allows a user to feel vibrations. The actuator 1 has the supporting body 5, the movable body 4, and the connecting body 7 connected to the movable body 4 and the supporting body 5, and the movable body 4 is supported by the supporting body 5 via the connecting body 7. Also, the actuator 1 has the first magnetic driving circuit 10 and the second magnetic driving circuit 20 for moving the movable body 4 relative to the supporting body 5 in the directions (the second direction L2 and the third direction L3) which intersect with one another. In this embodiment, the second direction L2 in which the first magnetic driving circuit 10 generates the driving force is the X-axis direction; the third direction L3 in which the second magnetic driving circuit 20 generates the driving force is the Y-axis direction; the second direction L2 and the third direction L3 intersect with each other perpendicularly.

In this embodiment, the supporting body 5 has the first case 53 positioned on one side Z1 of the Z-axis direction and the second case 54 covering the first case 53 on the other side Z2 of the Z-axis direction. The first case 53 is composed of a receptacle formed in a + (plus) shape when viewed from the Z-axis direction, and includes the end plate portion 531 and the body portion 532 protruding from the end plate portion toward the second case 54. The second case 54 is composed of a lid formed in a + (plus) shape when viewed from the Z-axis direction and is secured to the end portion of the body portion 532 on the other side Z2 of the Z-axis direction.

The movable body 4 has the plate member 48 having the thickness direction in the Z-direction, and the plate member 48 has a quadrangle planar shape which is smaller than the supporting body 5 when viewed from the Z-axis direction. Here, the first magnets 11 of the first magnetic driving circuit 10 are fixed to the two sides, out of four sides, of the plate member 48 which are opposed to each other in the second direction L2, and the second magnets 21 of the second magnetic driving circuits 20 are fixed to the two sides which are opposed to each other in the third direction L3.

The supporting body 5 has a plate member 55 secured to the end plate portion 531 of the first case 53; the plate member 55 holds the first coil 12 (Fig. 5 (b)) opposed to both of the two first magnets 11 on one side of the first direction L1 (on one side Z1 of the Z-axis direction) and the second coil (no illustration) opposed to both of the second magnets 21 on one side of the first direction L1 (on one side Z1 of the Z-axis direction).

Even in this embodiment, the connecting body 7 is composed of the gel damper member 70 provided between the movable body 4 and the supporting body 5 in the same manner as Embodiment 1. In this embodiment, the gel damper 70 is provided at four places between the end surface of the first magnet 11 on one side of the first direction L1 and the end plate portion 531 of the first case 53; the gel damper members 70 are also fixed to both the first magnets 11 and the first case 53 by a method of adhesive, etc. The gel damper member 70 is also provided at four places between the end surface of the first magnet 11 on the other side of the first direction L1 and the second case 54; the gel damper members 70 are fixed to both the first magnets 11 and the second case 54 by a method of adhesive, etc. Further, the gel damper member 70 is provided at four places, each of which is created over the side surface of the first magnet 11 and the side surface of the plate member 55; these gel damper members 70 are fixed to both the plate member 55 and the inside surface of the body portion 532 of the first case 53 by a method of adhesive or the like. In this embodiment, the gel damper member 7 is composed of a plate-like silicone gel.

Even in this embodiment, the first magnetic driving circuit 10 is arranged at two positions which are separated in the second direction L2 and appear to overlap when viewed from the second direction L2 in the same manner as Embodiment 1. Also, the second magnetic driving circuit 20 is arranged at two positions which are separated in the third direction L3 and appear to overlap when viewed from the third direction L3. Also, the first magnetic driving circuits 10 and the second magnetic driving circuits 20 are arranged to appear alternately around the center of gravity G of the movable body 4 when viewed from the first direction L1. Further, the first magnetic driving circuits 10 at the two positions are arranged to be point symmetry turned about the center of gravity G of the movable body 4 when viewed from the first direction L1, and the second magnetic driving circuits 20 at the two positions are arranged to be point symmetry turned about the center of gravity G of the movable body 4 when viewed from the first direction L1. Also, the first magnetic driving circuits 10 at the two positions are line symmetry reflected over an imaginary line (no illustration), which passes through the center of gravity G of the movable body 4 and extends in the third direction L3, when viewed from the first direction L1; the second magnetic driving circuits 20 at the two positions are line symmetry reflected over an imaginary line (no illustration), which passes through the center of gravity G of the movable body 4 and extends in the second direction L2, when viewed from the first direction L1. Also, the first magnetic driving circuits 10 and the second magnetic driving circuits 20 are at equal angle intervals around the center of gravity G of the movable body 4 when viewed from the first direction L1. Also, the first magnetic driving circuits 10 and the second magnetic driving circuits 20 are arranged at the same height in the first direction L1 when viewed from the directions intersecting perpendicularly with the first direction L1.

Even in the actuator 1 configured as above, the movable body 4 is supported by the connecting body 7 to the supporting body 5; provided between the movable body 4 and the supporting body 5 are the first magnetic driving circuit 10, which generates the driving force to drive [the movable body 4] in the second direction L2 perpendicularly intersecting with the first direction L1 with the coil and the magnets opposed in the first direction L1, and the second magnetic driving circuit 20, which generatse the driving force to drive the movable body 4 in the third direction L3 intersecting with the second direction L2 with the coil and the magnets opposed in the first direction L1. For this reason, the movable body 4 can be oscillated in the second direction L2 and also in the third direction L3. Therefore, a user can feel the vibrations in the second direction L2 and the vibrations in the third direction L3. Since the coil and the magnets are opposed to one another in the first direction L1 in the first magnetic driving circuit 10 or the second magnetic driving circuit 20, the same effect as in Embodiment 1 can be obtained, such that the size of the actuator 1 in the first direction L1 can be made small even when the first magnetic driving circuits 10 and the second magnetic driving circuits 20 are provided.

### [Embodiment 3]

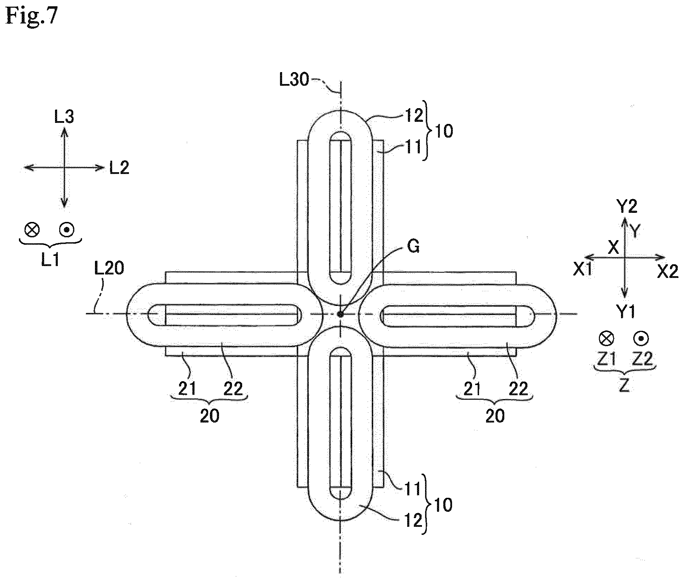

Fig. 7 is an explanatory diagram of a planar layout of a magnetic driving circuit in an actuator 1 of Embodiment 3 of the present invention. Note that Fig. 7 illustrates one coil and only one magnet among multiple members that configure a first magnetic driving circuit 10 or a second magnetic driving circuit 20.

As shown in Fig. 7, even in the actuator 1 of this embodiment, the first magnetic driving circuit 10 generates the driving force in the second direction L2 which perpendicularly intersects with the first direction L1 and the second magnetic driving circuit 20 generates the driving force in the third direction which intersects with the second direction L2, in the same manner as Embodiments 1 and 2. Here, the second direction L2 and the third direction L3 intersect with each other perpendicularly.

In this embodiment, the first magnetic driving circuit 10 is arranged at two positions which are separated in the third direction L3 and appear to overlap when viewed from the third direction L3. Also, the second magnetic driving circuit 20 is arranged at two positions which are separated in the second direction L2 and appear to overlap when viewed from the second direction L2.

Also, the first magnetic driving circuits 10 and the second magnetic driving circuits 20 are arranged to appear alternately around the center of gravity G of the movable body 4 when viewed from the first direction L1. Further, when viewed from the first direction L1, the first magnetic driving circuits 10 at the two places are arranged to be point symmetry turned about the center of gravity G of the movable body 4 (no illustration) and the second magnetic driving circuits 20 at the two positions are arranged to be point symmetry turned about the center of gravity G of the movable body 4. Also, the first magnetic driving circuits 10 at the two positions are line symmetry reflected over an imaginary line L30, which passes through the center of gravity G of the movable body 4 and extends in the third direction L3, when viewed from the first direction L1; the second magnetic driving circuits 20 at the two positions are line symmetry reflected over an imaginary line L20, which passes through the center of gravity G of the movable body 4 and extends in the second direction L2, when viewed from the first direction L1. Also, the first magnetic driving circuits 10 and the second magnetic driving circuits 20 are at equal angle intervals around the center of gravity G of the movable body 4 when viewed from the first direction L1. Also, the first magnetic driving circuits 10 and the second magnetic driving circuits 20 are at the same height in the first direction L1 when viewed from the directions intersecting perpendicularly with the first direction L1.

Even in the actuator 1 of this embodiment, the movable body 4 is oscillated in the second direction L2 by the two first magnetic driving circuits 10 in the same manner as Embodiment 1; therefore, the center of gravity in the actuator 1 deviates in the second direction L2. Also, the movable body 4 is oscillated in the third direction L3 by the two second magnetic driving circuits 20; therefore, the center of gravity in the actuator 1 deviates in the third direction L3. For this reason, a user can feel the vibrations in the second direction L2 and the vibrations in the third direction L3.

Also, when a negative phase AC is supplied to the two first coils 12 and a negative phase AC is supplied to the two second coils 22, the movable body 4 makes reciprocating rotation around the center of gravity G. Therefore, a user can feel vibrations around the center of gravity G.

### [Embodiment 4]

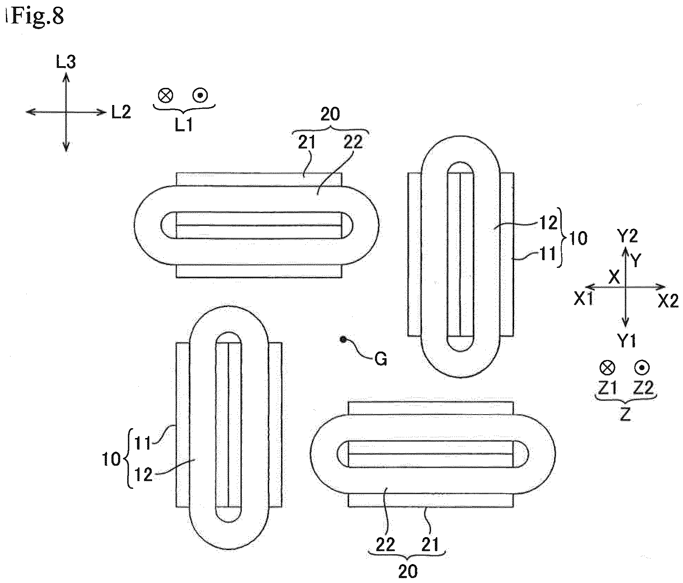

Fig. 8 is an explanatory diagram of a planar layout of magnetic driving circuits in an actuator 1 of Embodiment 4 of the present invention. Note that Fig. 8 illustrates one coil and only one magnet among multiple members that configure a first magnetic driving circuit 10 or a second magnetic driving circuit 20.

As shown in Fig. 8, even in the actuator 1 of this embodiment, the first magnetic driving circuits 10 generate the driving force in the second direction L2 which perpendicularly intersects with the first direction L1 and the second magnetic driving circuits 20 generate the driving force in the third direction L3 which intersects with the second direction L2, in the same manner as Embodiments 1 and 2. Here, the second direction L2 and the third direction L3 intersect with each other perpendicularly.

In this embodiment, the first magnetic driving circuit 10 is arranged at two positions which are separated in the third direction L2 and shifted in the third direction L3 when viewed from the second direction L2. Also, the second magnetic driving circuit 20 is arranged at two positions which are separated in the third direction L3 and shifted in the second direction L2 when viewed from the third direction L3.

Also, the first magnetic driving circuits 10 and the second magnetic driving circuits 20 are arranged to appear alternately around the center of gravity G of the movable body 4 when viewed from the first direction L1. Further, when viewed from the first direction L1, the first magnetic driving circuits 10 at the two position are arranged to be point symmetry turned about the center of gravity G of the movable body 4 (no illustration) and the second magnetic driving circuits 10 at the two positions are arranged to be point symmetry turned about the center of gravity G of the movable body 4. Also, the first magnetic driving circuits 10 and the second magnetic driving circuits 20 are at equal angle interval around the center of gravity G of the movable body 4 when viewed from the first direction L1. Also, the first magnetic driving circuits 10 and the second magnetic driving circuits 20 are at the same height in the first direction L1 when viewed from the directions intersecting with the first direction L1 perpendicularly.

Even in the actuator 1 of this embodiment, the movable body 4 is oscillated in the second direction L2 by the two first magnetic driving circuits 10 in the same manner as Embodiment 1; therefore, the center of gravity of the actuator 1 deviates in the second direction L2. Also, the movable body 4 is oscillated in the third direction L3 by the two second magnetic driving circuits 20; therefore, the center of gravity of the actuator 1 deviates in the third direction L3. For this reason, a user can feel the vibrations in the second direction L2 and the vibrations in the third direction L3.

Also, when a negative phase AC is supplied to the two first coils 12 and a negative phase AC is supplied to the two second coils 22, the movable body 4 makes reciprocating rotations around the center of gravity G. Therefore, a user can feel vibrations around the center of gravity G.

### [Embodiment 5]

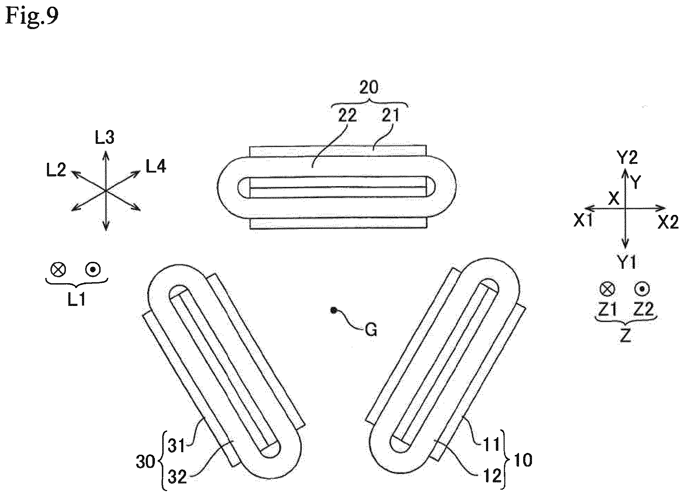

Fig. 9 is an explanatory diagram of a planar layout of magnetic driving circuits in an actuator 1 of Embodiment 5 of the present invention. Note that Fig. 9 illustrates one coil and only one magnet among multiple members that configure a first magnetic driving circuit 10, a second magnetic driving circuit 20 and a third magnetic driving circuit 30.

As shown in Fig. 9, even in the actuator 1 of this embodiment, the first magnetic driving circuit 10 generates the driving force in the second direction L2 which perpendicularly intersects with the first direction L1 and the second magnetic driving circuit 20 generates the driving force in the third direction L3 which perpendicularly intersects with the first direction L1 and intersects with the second direction L2, in the same manner as Embodiments 1 and 2.

Furthermore, the actuator 1 of this embodiment has third magnets 31 and a third coil 32 opposed to the third magnets 31 in the first direction L1 (the Z-axial direction), which together generate the driving force in a fourth direction L4 which diagonally intersects with the second direction L2 and the third direction L3.

At this time, the second direction L2 and the third direction L3 diagonally intersect with each other, the third direction L3 and the fourth direction L4 diagonally intersect with each other, and the second direction L2 and the fourth direction L4 diagonally intersect with each other. The first magnetic driving circuit 10, the second magnetic driving circuit 20 and the third magnetic driving circuit 30 are respectively provided at one position.

When viewed from the first direction L1, the first magnetic driving circuit 10, the second magnetic driving circuit 20 and the third magnetic driving circuit 30 are rotational symmetry about the center of gravity G of the movable body 4 (no illustration), and they are at equal angle intervals around the center of gravity G of the movable body 4. Also, when viewed from the directions which perpendicularly intersecting with the first direction L1, the first magnetic driving circuit 10, the second magnetic driving circuit 20 and the third magnetic driving circuit 30 are at the same position in the first direction L1.

Even in the actuator 1 of this embodiment, the movable body 4 is oscillated in the second direction L2 when an AC is applied to the first coil 12 of the first magnetic driving circuit 10 while the current supply to the second coil 22 of the second magnetic driving circuit 20 and the third coil 32 of the third magnetic driving circuit 30 is halted, in the same manner as in Embodiment 1; therefore, the center of gravity in the actuator 1 deviates in the second direction L2. Also, by applying an AC to the second coil 22 of the second magnetic driving circuit 20 but halting the current supply to the first coil 12 of the first magnetic driving circuit 10 and the third coil 32 of the third magnetic driving circuit 30, the movable body 4 is oscillated in the third direction L3. Further, by applying an AC to the third coil 32 of the third magnetic driving circuit 10 but halting the current supply to the first coil 12 of the first magnetic driving circuit 10 and the second coil 22 of the second magnetic driving circuit 20, the movable body 4 is oscillated in the fourth direction L4; therefore, the center of gravity in the actuator 1 deviates in the third direction L3. For this reason, a user can feel the vibrations in the second direction L2, the vibrations in the third direction L3 and the vibrations in the fourth direction L4.

Also, by combining the electrification to the first coil 12, the electrification to the second coil 22, and the electrification to the third coil 33, a user can feel the combined vibrations of the second direction L2, the third direction L3 and the fourth direction L4. For example, by combining the electrification to the first coil 12, the electrification to the second coil 22 and electrification to the third coil 32, a user can feel the vibration in the X-axial direction X and the vibration in the Y-axial direction Y.

### [Embodiment 6]

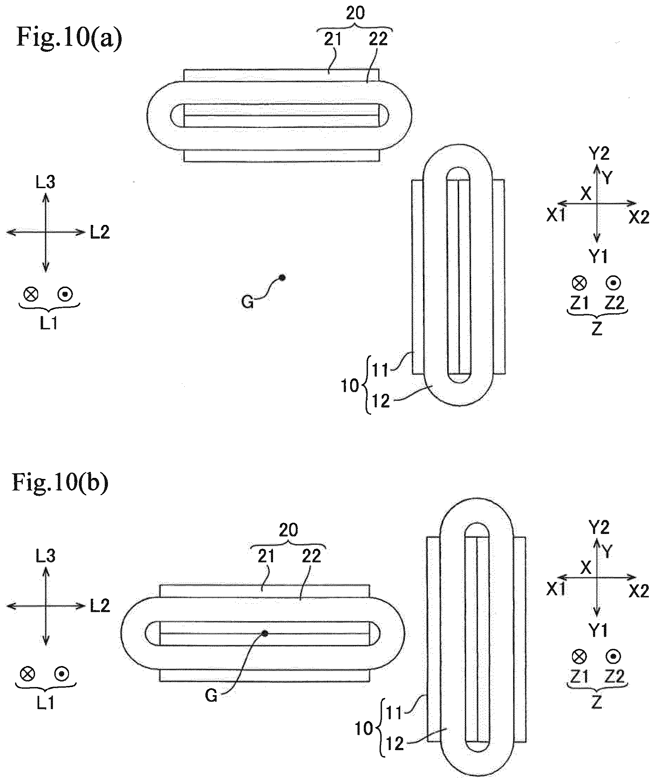

Fig. 10 is an explanatory diagram of magnetic driving circuits of an actuator 1 of Embodiment 6 of the present invention: Fig. 10 (a) and (b) are respectively an explanatory diagram of a planar layout of the magnetic driving circuits and an explanatory diagram of another planar layout of the magnetic driving circuits. Note that Fig. 10 illustrates only one coil and only one magnet among multiple members that configure the first magnetic driving circuit 10 or the second magnetic driving circuit 20.

In Embodiment 1, eight magnets and eight (four) coils are used in total, and in Embodiment 2 (5), three magnets and three coils are used in total; however, in this embodiment, two magnets and two coils are used in total.

More specifically described, as shown in Fig. 10 (a) and (b), the first magnetic driving circuit 10 generates the driving force in the second direction L2 which perpendicularly intersects with the first direction L1 and the second magnetic driving circuit 20 generates the driving force in the third direction L3 which perpendicularly intersects with the first direction L1 and intersects with the second direction L2 in the actuator 1 of this embodiment, as in Embodiments 1 and 2. Here, the second direction L2 and the third direction L3 perpendicularly intersect with one another.

In the embodiment shown by Fig. 10 (a), the first magnetic driving circuit 10 is arranged at the position which is away from the center of gravity G of the movable body 4 (no illustration) in the second direction L2 when viewed from the first direction L1, and the second magnetic driving circuit 20 is arranged at the position which is away from the center of gravity G of the movable body 4 (no illustration) in the third direction L3 when viewed from the first direction L1. Also, in the embodiment shown by Fig. 10 (b), the first magnetic driving circuit 10 is arranged at the position which is away from the center of gravity G of the movable body 4 (no illustration) in the second direction L2 when viewed from the first direction L1, and the second magnetic driving circuit 20 is arranged at the position which overlaps with the center of gravity G of the movable body (no illustration) when viewed in the first direction L1.

Even in the actuator 1 of this embodiment, the movable body 4 is oscillated in the second direction L2 by the first magnetic circuit 10 in the same manner as Embodiment 1; therefore, the center of gravity in the actuator 1 deviates in the second direction L2. Also, the movable body 4 is oscillated in the third direction L3 by the second magnetic driving circuit 20; therefore, the center of gravity in the actuator 1 deviates in the third direction L3. For this reason, a user can feel the vibrations in the second direction L2 and the vibrations in the third direction L3.

Here, in the embodiment shown by Fig. 10 (b), the second magnetic driving circuit 20 is arranged at the position which overlaps with the center of gravity G of the movable body 4 (no illustration) when viewed from the first direction L1; therefore, when the movable body 4 is oscillated in the third direction L3, the movable body 4 can be prevented from rotating about the center of gravity G.

### [Embodiment 7]

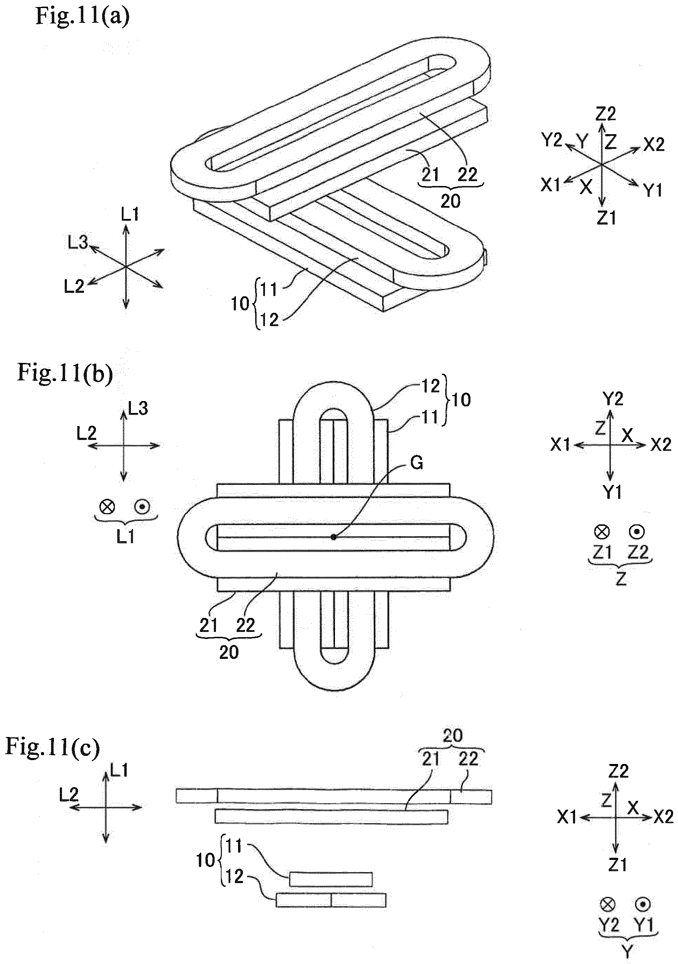

Fig. 11 is an explanatory diagram of magnetic driving circuits of an actuator 1 of Embodiment 7 of the present invention: Fig. 11 (a), (b) and (c) are respectively a perspective view, a plan view and a side view of the magnetic driving circuits. Note that in the first magnetic driving circuit 10, one coil and only one magnet are illustrated among multiple members that configure the first magnetic driving circuit 10 or the second magnetic driving circuit 20.

In the above Embodiment 1, all the magnetic driving circuits are arranged at the same position in the first direction L1 when viewed from the direction perpendicularly intersecting with the first direction L1; however, in this embodiment and Embodiment 8 which will be described later, the first magnetic driving circuit 10 and the second magnetic driving circuit 20 partially overlap with one another when viewed from the first direction L1.

More specifically described, as shown in Fig. 11, even in the actuator 1 of this embodiment, the first magnetic driving circuit 10 generates the driving force in the second direction L2, which perpendicularly intersects with the first direction L1, as in Embodiments 1 and 2. The second magnetic driving circuit 20 generates the driving force in the third direction L3 which perpendicularly intersects with the first direction L1 and crosses with the second direction L2. Here, the second direction L2 and the third direction L3 perpendicularly intersect with one another.

When viewed from the first direction L1, the first magnetic driving circuit 10 is arranged at the position which overlaps with the center of gravity G of the movable body 4 (no illustration) and the second magnetic driving circuit 20 is arranged at the position which overlaps with the center of gravity G of the movable body 4 (no illustration) in the same manner as the first magnetic driving circuit 10. Thus, the first magnetic driving circuit 10 and the second magnetic driving circuit 20 partially overlap with one another when viewed from the first direction L1. Therefore, the size of the actuator 1 when viewed in the first direction L1 can be minimized.

Even in the actuator 1 of this embodiment, the movable body 4 is oscillated in the second direction L2 by the first magnetic driving circuit 10, and therefore, the center of gravity in the actuator 1 deviates in the second direction L2 in the same manner Embodiment 1. Also, the movable body 4 is oscillated in the third direction L3 by the second magnetic driving circuit 20; therefore, the center of gravity in the actuator 1 deviates in the third direction L3. For these reasons, a user can feel the vibrations in the second direction L2 and the vibrations in the third direction L3.

Here, the first magnetic driving circuit 10 and the second magnetic driving circuit 20 are arranged at the positions which overlap with the center of gravity of the movable body 4 (no illustration) when viewed in the first direction L1; therefore, when oscillated in the second direction L2 and in the third direction L3, the movable body 4 is kept from rotating about the center of gravity G.

### [Embodiment 8]

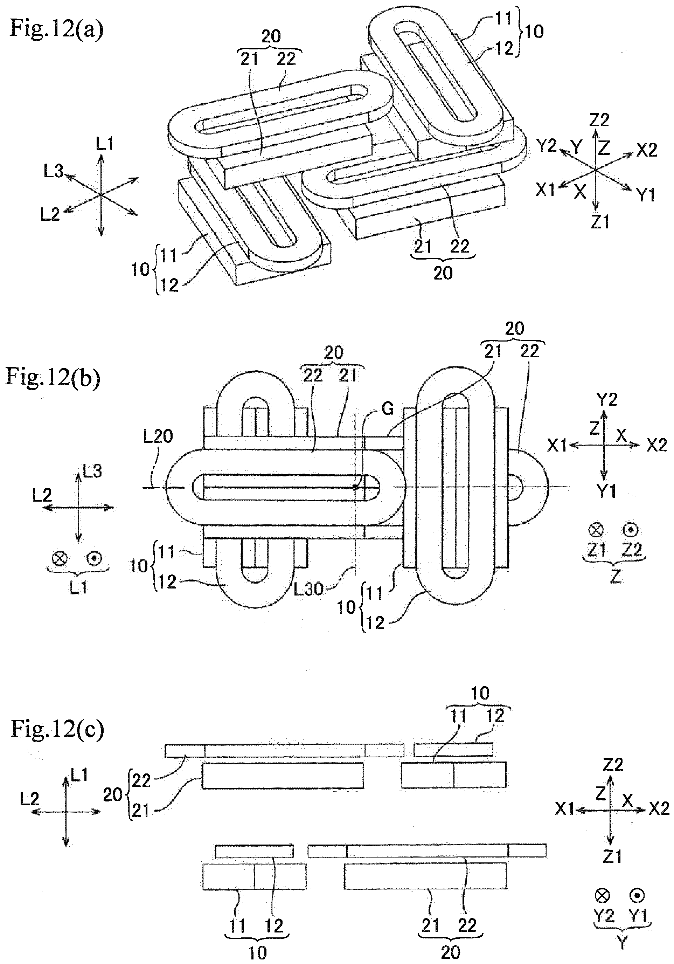

Fig. 12 is an explanatory diagram of magnetic driving circuits of an actuator 1 of Embodiment 8 of this embodiment: Fig. 12 (a), (b) and (c) are respectively a perspective view, a plan view and a side view of the magnetic driving circuits. Note that Fig. 12 illustrates only one coil and one magnet among the multiple members that configure the first magnetic driving circuit 10 or the second magnetic driving circuits 20.

In the above-described Embodiment 7, one first magnetic driving circuit 10 and one second magnetic driving circuit 20 are provided; however, in this embodiment, two first magnetic driving circuits 10 and two second magnetic driving circuits 20 are provided, and the first magnetic driving circuits 10 and the magnetic driving circuits 20 partially overlap with one another when viewed from the direction which perpendicularly intersects with the first direction L1.

More specifically described, as shown in Fig. 12, even in the actuator 1 of this embodiment, the first magnetic driving circuits 10 generate the driving force in the second direction L2 which perpendicularly intersects with the first direction L1 and the second magnetic driving circuits 20 generate the driving force in the third direction L3 which perpendicularly intersects with the first direction L1 and crosses with the second direction L2, in the same manner as in Embodiments 1 and 2. Here, the second direction L2 and the third direction L3 perpendicularly intersect with one another.

Here, the first magnetic driving circuit 10 is arranged at two positions which are away from the center of gravity G of the movable body 4 (no illustration) in the second direction L2, and the second magnetic driving circuits 20 are arranged at two positions which overlap with the center of gravity G of the movable body 4 (no illustration) and are apart from one another in the first direction L1. For this reason, when viewed from the first direction 11, the first magnetic driving circuit 10 and the second magnetic driving circuit 20 partially overlap with one another and the two second magnetic driving circuits 20 partially overlap with one another. Therefore, the size of the actuator 1 when viewed from the first direction L1 can be minimized.

Even in the actuator 1 of this embodiment, the movable body 4 is oscillated in the second direction L2 by the first magnetic driving circuits 10 in the same manner as in Embodiment 1, and therefore, the center of gravity in the actuator 1 deviates in the second direction L2. In the same way, the movable body 4 is oscillated in the third direction L3 by the second magnetic driving circuits 20, and therefore, the center of gravity in the actuator 1 deviates in the third direction L3. For this reason, a user can feel the vibrations in the second direction L2 and the vibrations in the third direction L3.

The first magnetic driving circuits 10 arranged at the two positions are point symmetry turned about the center of gravity G of the movable body 4 when viewed from the first direction L1, and the second magnetic driving circuits 20 arranged at the two positions are also point symmetry turned about the center of gravity G of the movable body 4 when viewed from the first direction L1. Also, when viewed from the first direction L1, the first magnetic driving circuits 10 at the two positions are line symmetry reflected over an imaginary line L30 passing through the center of gravity G of the movable body 4 and extending in the third direction L3, and the second magnetic driving circuits 20 at the two positions are line symmetry reflected over an imaginary line L20 passing through the center of gravity G of the movable body 4 and extending in the second direction L2. For this reason, when oscillated in the second direction L2 and in the third direction L3, the movable body 4 can be restricted from rotating around the center of gravity G.

### [Embodiment 9]

### (Overall Configuration)

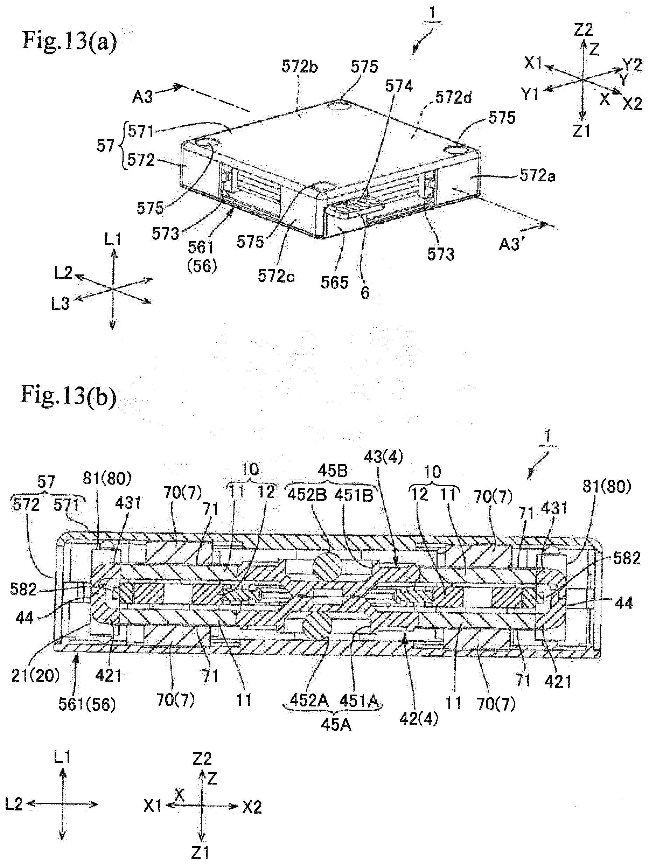

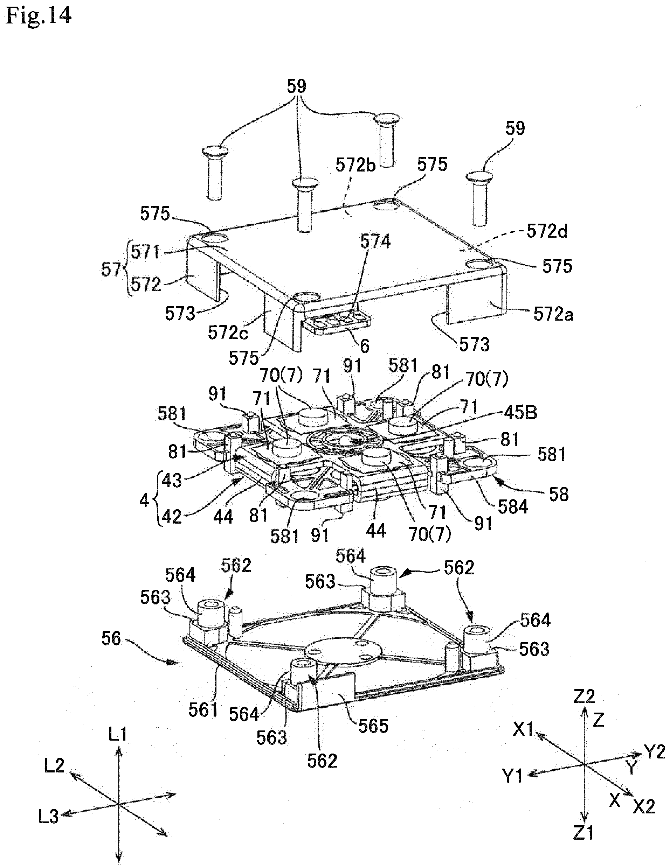

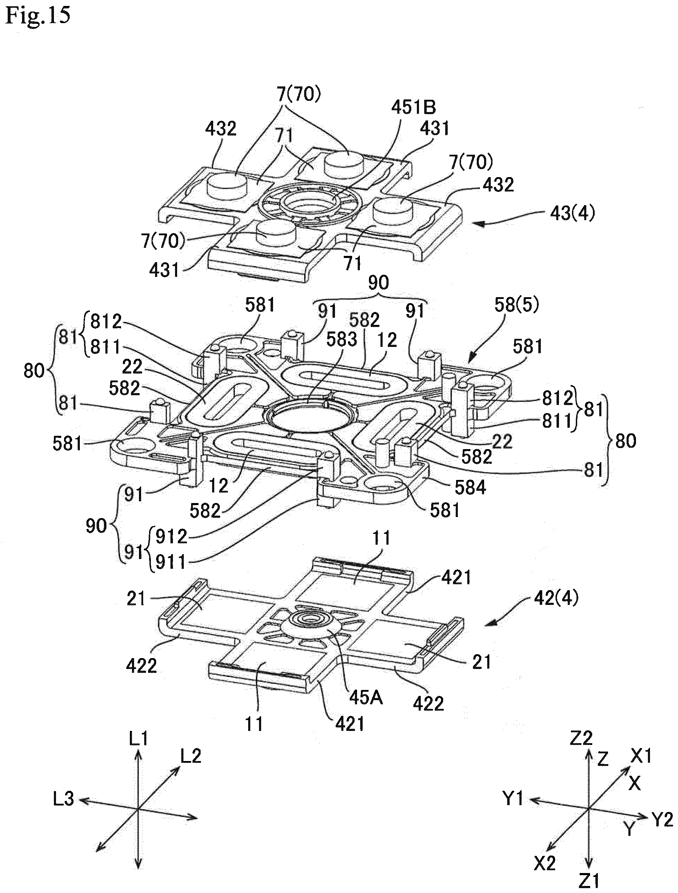

Fig. 13 is an explanatory diagram of an actuator 1 of Embodiment 9 of the present invention: Fig. 13 (a) is a perspective view of the actuator 1 and Fig. 13 (b) is an XZ cross-sectional view the actuator 1 sectioned along an A3-A3' line passing through the center portion of the actuator 1. Fig. 14 is an exploded perspective view of the actuator 1 of Fig. 13, and Fig. 15 is an exploded perspective view of a major portion of the actuator 1 of Fig. 13. Note that since a basic configuration of this embodiment remains the same as in Embodiments 1 and 2, the same codes are given to the corresponding components and their descriptions are omitted. The actuator 1 is configured in the same manner as Embodiment 2 in that the coils (the first coil 12 and the second coil 22) are held to the supporting body 5 and the magnets (the first magnet 11 and the second magnet 21) are held to the movable body 4.

Like other embodiments, the actuator 1 of this embodiment is an oscillation actuator that allows a user to feel vibrations. The actuator 1 has the supporting body 5, the movable body 4, and the connecting body 7 which is connected between the movable body 4 and the supporting body 5; the movable body 4 is supported by the supporting body 5 via the connecting body 7. Also, the actuator 1 has the first magnetic driving circuits 10 and the second magnetic driving circuits 20 as the magnetic driving circuits for moving the movable body 4 relative to the supporting body 5 in the directions which intersect with one another (in the second direction L2 and the third direction L3). In this embodiment, the second direction L2 in which the first magnetic driving circuits 10 generate the driving force is the X-axis direction; the third direction L3 in which the second magnetic driving circuits 20 generate the driving force is the Y-axis direction.

In this embodiment, the supporting body 5 has a first case 56 positioned on one side Z1 of the Z-axis direction, a second case 57 covering the first case 56 from the other side Z2 of the Z-axis direction, a plate-like member 58 positioned between the first case 56 and the second case 57, and four captive screws 59 for fixing the first case 56 and the second case 57 together. The second case 57 has an end plate portion 571, which is in a quadrangle flat shape when viewed in the Z-axis direction, and a body portion 572 protruding from the end plate portion 571 toward the first case 56. The body portion 572 is provided with a first surface 572a facing one side of the second direction L2 (the X-axis direction), a second surface 572b facing the other side [of the second direction L2], a third surface 572 facing one side of the third direction L3 (the Y-axis direction) and a fourth surface 572d facing the other side [of the third direction L3]. A notch 573 cut from one side Z1 to the other side Z2 of the Z-axis direction is formed in the center portions in the first surface 572a and the second surface 572b along the third direction L3 and in the center portions of the third surface 572c and the fourth surface 572d along the second direction L2. Also, another notch 574 is formed by further cutting out a portion in the height in Z-axis direction, next to the notch 573, in the first surface 572a.

The first case 56 is provided with an end plate portion 561, which is in a quadrangle flat shape when viewed from the Z-axis direction, and boss portions 562 protruding from the four corners of the end plate portion 561 toward the end plate portion 571 of the second case 57. Each of the boss portions 562 is provided with a step surface 563 formed at a position in the Z-axis direction and a cylindrical portion 564 protruding from the step surface 563 toward the other side Z2 of the Z-axis direction. At four corners of the end plate portion 571 of the second case 57, fixing holes 575 are formed. By screwing the captive screws 59 to the fixing holes 575 of the second case 57 and to the boss portions 562 of the first case 56 together from the other side Z2 of the Z-axis direction, the end plate portion 571 of the first case 56 can be fixed to the end portion of the body portion 572 on one side Z1 of the Z-axis direction. The first case 56 is provided with a rising portion 565 which is opposed to the notch portion 574 in the second case 57 in the first direction L1. The rising portion 565 creates a slit with the notch portion 574 for a substrate to be positioned. To the substrate 6, a supply line to the first coils 12 and the second coils 22, and the like are connected.

A circular hole 581 is opened at the four corners of the plate-like member 58. Having the cylindrical portions 564 of the boss portions 562 inserted into the circular holes 581 and rested on the step surfaces 563, the plate-like member 58 is held. In the middle portion along each of the four sides of the plate-like member 58, a recess portion 582 is formed (referring to Fig. 15) to recess toward the inner circumference side. The first coils 12 of the first magnetic driving circuits 10 are held inside of the two recess portions 582 which are opposed in the second direction L2. Also, the second coils 22 of the second magnetic driving circuits 10 are held inside of the two recess portions 582 which are opposed in the third direction L3. The first coil 12 is a flat air core inductor having the longitudinal sides, which are the effective sides, extend in the third direction L3; the second coil 22 is a flat air core inductor having the longitudinal sides, which are the effective sides, extend in the second direction L2. The first coils 12 and the second coils 22 are mounted into the through holes formed in the plate-like member 58.

The movable body 4 has a first holding member 42 positioned on one side Z1 in the Z-axis direction of the plate-like member 58 and a second holding member 43 positioned on the other side Z2 in the Z-axis direction of the plate-like member 58. The first holding member 42 and the second holding member 43 are in a "+" (plus) shape when viewed from the Z-axis direction. The first holding member 42 and the second holding member 43 together form a joint portion 44 in which the leading edges of the portions protruding to both sides in the second direction L2 and in the third direction L3 are bent in the opposite directions and connected in a U-shape. The movable body 4 is smaller in the exterior shape than the plate-like member 58 when viewed from the Z-axis direction, and the joint portion 44 is arranged in a gap between the recess portion 582 of the plate-like member 58 and the body portion 572 of the second case 57 (referring to Fig. 13 (b)).

The center portion of the first holding member 42 and the center portion of the second holding member 43 are connected in the Z-axis direction, through the circular hole 583, which is formed in the center portion of the plate-like member 58 and in which a first bearing 45A and a second bearing 45B are arranged. The first bearing 45A is arranged in the center of the first holding member 42 and provided with a circular recess portion 451A which is recessed from one side Z1 of the Z-axis direction toward the other side Z2 and a spherical body 452A which is capable of rolling between the bottom surface of the circular recess portion 451A and the end plate portion 561 of the first case 56. The second bearing 45B is arranged in the center of the second holding member 43 and provided with a circular recess portion 451B which is recessed from the other side Z2 of the Z-axis direction toward one side Z1 and a spherical body 452B which is capable of rolling between the bottom surface of the circular recess portion 451B and the end plate portion 571 of the second case 57. Note that the movable body 4 can be configured without the first bearing 45A and the second bearing 45B.

Even in this embodiment, the connecting body 7 is composed of a gel damper member 70 provided between the movable body 4 and the supporting body 5. In other words, the connecting body 7 is configured by four gel damper members 70 provided between the first holding member 42 of the movable body 4 and the first case 56 and four gel damper members 43 provided between the second holding member 43 and the end plate portion 571 of the second case 57. The first holding member 42 is provided with a first magnet holding portion 421, which extends to one side and to the other side of the second direction L2 and a second magnet holding member 422 which extends to one side and to the other side of the third direction L3; the gel damper member 70 is arranged in every space between the four magnet holding portions and the end plate portion 561 of the first case 56. The second holding member 43 is provided with a first magnet holding portion 431, which extends to one side and to the other side of the second direction L2 and a second magnet holding member 432 which extends to one side and to the other side of the third direction L3; the gel damper member 70 is arranged in every space between the four magnet holding portions and the end plate portion 571 of the second case 56.

The first magnet holding portion 421 and the first magnet holding portion 431 hold the first magnets 11 of the first magnetic driving circuits 10. A rectangular through-hole is formed in each the first magnet holding portion 421 and the first magnet holding portion 431 for mounting the first magnet 11. Between the first magnets 11 and the gel damper members 70, rectangular yokes 71 are arranged. The second magnet holding portion 422 and the second magnet holding portion 432 hold the second magnets 12 of the second magnetic driving circuits 20. A rectangular through portion is formed in each the second magnet holding portion 422 and the second magnet holding portion 432 for mounting the second magnet 12. Between the second magnets12 and the gel damper members 70, rectangular yokes 71 are arranged. The gel damper members 70 are fixed to the yokes 71 of the movable body 4 and the end plate portion 561 and the end plate portion 571 of the supporting body 5 by a method of adhesive.

In this embodiment, the gel damper member 70 is composed of a sheet-like silicone gel. The planar shape of the gel damper member 70 is circular in this embodiment; however, it may be polygonal such as rectangle. The rectangle shape is the best for the manufacturing yield of the gel damper member 70, and therefore, at low cost. However, considering the resonance properties of the movable body 4 for driving the actuator 1, it is desirable that the gel damper member 70 be formed circular.

In this embodiment, the first magnetic driving circuit 10 is provided with the first coil 12 held by the plate-like member 58 and the first magnets 11 held by the movable body 4 at both ends of the plate-like member 58 in the first direction L1; the first magnets 11 and the first coil 12 are opposed to one another in the first direction L1 and, when the first coil 12 is electrified, generate the driving force to drive the movable body 4 in the second direction L2 which perpendicularly intersects with the first direction L1. Also, the second magnetic driving circuit 20 is provided with the second coil 22 held by the plate-like member 58 and the second magnets 21 held by the movable body 4 at both ends of the plate-like member 58 in the first direction L1; the second magnets 21 and the second coil 22 are opposed to one another in the first direction L1 and, when the second coil 22 is electrified, generate the driving force to drive the movable body 4 in the third direction L3 which perpendicularly intersects with the second direction L2. For this reason, the movable body 4 can be oscillated in the second direction L2 and in the third direction L3 as well. Therefore, a user can feel the vibrations in the second direction L2 as well as the vibrations in the third direction L3. Further, in either the first magnetic driving circuit 10 or the second magnetic driving circuit 20, the coil and magnets are opposed to one another in the first direction L1; therefore, even when the first magnetic driving circuits 10 and the second magnetic driving circuits 20 are provided, the size of the actuator in the first direction can be minimized, demonstrating the same effects as in Embodiments 1 and 2.

### (Movement-regulating portion)

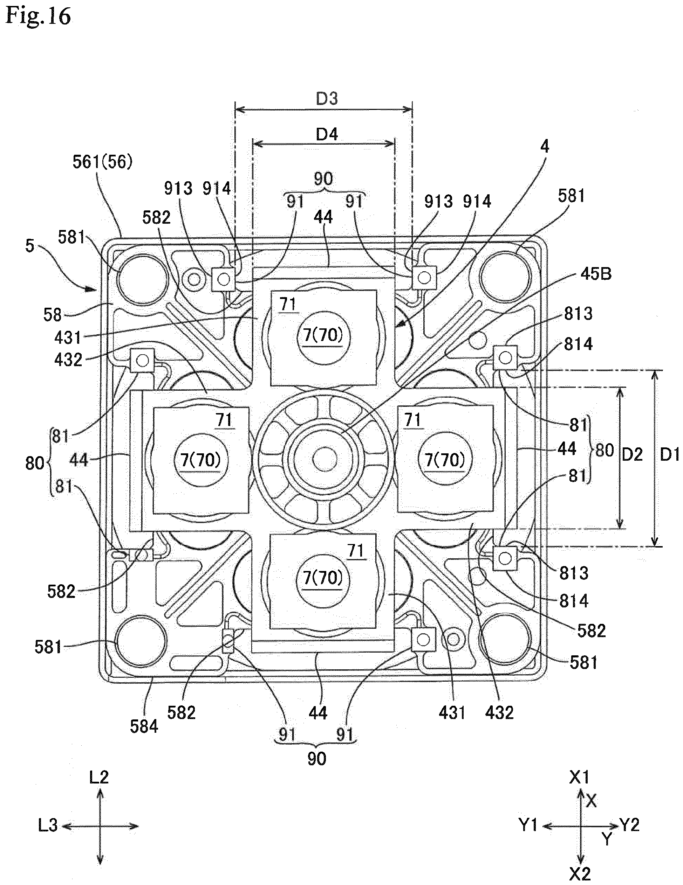

Fig. 16 is a plan view of an actuator 1 having the second case 57 removed. As shown in Fig. 15 and Fig. 16, the supporting body 5 of this embodiment is provided with first movement-regulating portions 80 for regulating the moving range of the movable body 4 in the second direction L2 and second movement-regulating portions 90 for regulating the moving range of the movable body 4 in the third direction L3. The first movement-regulating portions 80 and the second movement-regulating portions 90 are formed on the plate-like member 58. The plate-like member 58 is provided with the above-described circular holes 581, the recess portions 582, thin sheet portions in which the circular holes are formed, and prism portions 81 and prism portions 91 which are perpendicular to the thin sheet portions 584. The first movement-regulating portions 80 has two pairs (which means four) of prism portions 81 which are respectively opposed to each other on both sides of the second magnet holding portion 422 and the second magnet holding portion 432 in the second direction L2. The second movement-regulating portions 80 has two pairs (which means four) of prism portions 91 which are respectively opposed to each other on both sides of the first magnet holding portion 421 and the first magnet holding portion 431 of the movable body 4 in the third direction L3.

The prism portions 81 which configure the first movement-regulating portions 80 are positioned on the inner circumferential edges opposed in the second direction L2 at each of the two recess portions 582 opposed in the third direction L3. [Each of] the prism portion 81 is provided with a side face 813 and a side face 814 which are opposed to one another in the second direction L2; the side faces 813 and 814 are perpendicular to the oscillating direction when the movable body 4 is oscillated in the second direction L2. Also, [each of] the prism portions 91 is provided with a side face 913 and a side face 914 which are opposed to one another in the third direction L3; the side faces 913 and 914 are perpendicular to the oscillating direction when the movable body 4 is oscillated in the second direction L2.

As shown in Fig. 15, the prism portion 81 is configured by a first protruding portion 811 protruding from the thin sheet portion 584 toward the end plate portion 561 of the first case 56 and a second protruding portion 812 protruding from the thin sheet portion 584 toward the end plate portion 571 of the second case 57. The first protruding portion 811 and the second protruding portion 812 protrude from the thin sheet portion 584 in the opposite directions for the same protruding length; when viewed from the second direction L2 (the X-axis direction), the first protruding portion 811 overlaps with the second magnet holding portion 422 and the second protruding portion 812 overlaps with the second magnet holding portion 432. Therefore, when oscillated in the second direction L2, the movable body 4 is regulated from moving to one side or the other side of the second direction L2 by the prism portions 81. The movable body 4 can be oscillated within the range of the dimensional difference between the distance D1, which is measured between the prism portions 81, which are opposed on both sides of the second distance L2 of the second magnet holding portion 422 or the second magnet holding portion 432, and the width D2, which is the length of the second magnet holding portion 422 or the second magnet holding portion 432 in the second direction L2. Also, the prism portions 81 abut on the movable body 4 at the positions different from the joint portions 44, each of which is formed by connecting the first holding member 42 and the second holding member 43 in a U-shape, to regulate the movement of the movable body 4.

In the same manner, the prism portion 91 is configured by a first protruding portion 911 protruding from the thin sheet portion 584 toward the end plate portion 561 of the first case 56 and a second protruding portion 912 protruding from the thin sheet portion 584 toward the end plate portion 571of the second case 571. The first protruding portion 911 and the second protruding portion 912 protrude from the thin sheet portion 584 in the opposite direction for the same length; when viewed from the third direction L3 (the Y-axis direction), the first protruding portion 911 overlaps with the second magnet holding portion 422 and the second protruding portion 912 overlaps with the second magnet holding portion 432. Therefore, when oscillated in the third direction L3, the movable body 4 is restricted from moving to either one side or the other side of the third direction L3 by the prism portions 91. The movable body 4 can be oscillated in the range of the dimensional difference between the distance D3, which is measured between the prism portions 91 opposed on both sides of the first magnet holding portion 421 or the first magnet holding portion 431 in the third direction L3, and the width D4, which is the length of the first magnet holding portion 421 or the first magnet holding portion 431 in the third direction L3. Also, the prisms 91 abut on the movable body 4 at the positions different from the joint portions 44, each of which is formed by connecting the first holding member 42 and the second holding member 43 in a U-shape, to regulate the movement of the movable body 4.

Thus, in the actuator 1 of this embodiment, the supporting body 5 is provided with the first movement-regulating portion 80 and the second movement-regulating portion 90 so that the moving range of the movable body 4 in the second direction L2 and in the third direction L3 can be regulated. The moving range in the second direction L2 regulated by the first movement-regulating portion 80 and the moving range in the third direction L3 regulated by the second movement-regulating portion 90 are set within the range in which the movable body 4 does not collide with the body portion 572 of the second case 57. Also, when the movable body 4 is oscillated in the second direction L2 and in the third direction L3, the connecting body 7 (the gel damper member 70) is deformed in the shear direction. In this embodiment, the moving range of the movable body 4 is set less than the ultimate deformation amount of the gel damper member 70 in the shear direction. Therefore, even if the movable body 4 makes maximum oscillations, the gel damper members 70 do not stretch more than the ultimate deformation amount; therefore, a damage to the gel damper members 70 can be avoided.

The first movement-regulating portions 80 and the second movement-regulating portions 90 are arranged to abut on the movable body 4 at the positions different from the joint portions 44, each of which is formed by connecting the first holding member 42 with the second holding member 43 in a U-shape; thus, the portions of the movable body 4 with a weak strength does not get hit by the first movement-regulating portions 80 or the second movement-regulating portions 90. Therefore, it is less likely that the movable body 4 will be broken by colliding with the first movement-regulating portions 80 or the second movement-regulating portions 90.

The actuator 1 of this embodiment is configured such that the first magnets 11 are opposed to the first coil 12 from both sides [of the coil 12] and the second magnets 21 are opposed to the second coil 22 from both sides [of the coil 22]; therefore, there is less magnetic flux leakage compared to the configuration in which a magnet is opposed to only one side of a coil. Therefore, the thrust to move the movable body 4 can be increased.

Note that either the first movement-regulating portions 80 or the second movement-regulating portions 90 can be omitted. Also, in this embodiment, the first movement-regulating portions 80 and the second movement-regulating portions 90 are arranged to the plate-like member 58; however, they can be arranged to the first case 56 or the second case 57.

### [Other Embodiments]

In the above embodiments, the magnet and the coil are opposed via a gap; however, a resin protective sheet may be provided between the magnet and the coil to prevent damage to the magnet and the coil, which may be caused when in contact.

In the above embodiments, only the gel damper members 70 are used for the connecting body 7; however, the connecting body 7 may be in a form of a spring or in a form of using a spring and the gel damper member 70 together.

## Claims

1. An actuator comprising:
a supporting body;
a movable body;
a connecting body which is connected to said movable body and said supporting body and has elasticity or viscoelasticity at least;
a first magnetic driving circuit, provided with first magnets which are held by said supporting body or said movable body and a first coil which is held by the other and opposed to said first magnets in a first direction, to generate a driving force to drive said movable body in a second direction which perpendicularly intersects with said first direction; and
a second magnetic driving circuit, provided with second magnets which are held by said supporting body or the movable body and a second coil held by the other and opposed to said second magnets in said first direction to generate a driving force to drive said movable body in a third direction which perpendicularly intersects with said first direction and crosses said second direction.

2. The actuator as set forth in Claim 1 wherein, when viewed from the directions perpendicular to said first direction, said first magnetic driving circuit and said second magnetic driving circuit are at the same positions in said first direction.

3. The actuator as set forth in Claim 2 wherein said second direction and said third direction perpendicularly intersect with one another.

4. The actuator as set forth in Claim 3 wherein
said first magnetic driving circuit is arranged at two positions which are separated in said second direction and overlap with one another when viewed from said second direction; and
said second magnetic driving circuit is arranged at two positions which are separated in said third direction and overlap with one another when viewed from said third direction.

5. The actuator as set forth in Claim 3 wherein
said first magnetic driving circuit is arranged at two positions which are separated in said third direction and overlap with one another when viewed from said third direction; and
said second magnetic driving circuit is arranged at two positions which are separated in said second direction and overlap with one another when viewed from said second direction.

6. The actuator as set forth in Claim 3 wherein
said first magnetic driving circuit is arranged at two positions which are separated in said second direction and shifted from one another when viewed from said second direction; and
said second magnetic driving circuit is arranged at two positions which are separated in said third direction and shifted from one another when viewed from said third direction.

7. The actuator as set forth in any one of Claims 4 through 6 wherein said first magnetic driving circuits and said second magnetic driving circuits are arranged alternately around the center of gravity of said movable body.

8. The actuator as set forth in Claims 7 wherein
said first magnetic driving circuits arranged at said two positions are point symmetry turned about said center of gravity, and said second magnetic driving circuits arranged at said two positions are point symmetry turned about said center of gravity.

9. The actuator as set forth in Claim 8 wherein said first magnetic driving circuits arranged at said two positions are line symmetry reflected over an imaginary line which passes through said center of gravity and extends in said third direction; and
said second magnetic driving circuits are line symmetry reflected over an imaginary line which passes through said center of gravity and extends in said second direction.

10. The actuator as set forth in Claim 1 wherein said first magnetic driving circuit and said second magnetic circuit overlap at least partially with one another when viewed from said first direction.

11. The actuator as set forth in Claim 1 further comprising:
a third magnetic driving circuit having third magnets which are held by either said supporting body or said movable body and a third coil which is held by the other and opposed to said third magnets in said first direction, to generate a driving force to drive said movable body in a fourth direction which perpendicularly intersects with said first direction and diagonally intersects with said second direction and said third direction.

12. The actuator as set forth in Claim 10 wherein said second direction and said third direction diagonally intersect with one another.

13. The actuator as set forth in any one of Claims 1 through 12 wherein at least a gel damper member is used for said connecting body.

14. The actuator as set forth in Claim 13 wherein only said gel damper member is used for said connecting body.

15. The actuator as set forth in Claim 13 or Claim 14 wherein said gel damper member is secured to both said movable body and said supporting body.

16. The actuator as set forth in any one of Claims 13 through 15 wherein said gel damper member is composed of silicone gel.

17. The actuator as set forth in any one of Claims 1 through 16 wherein said supporting body is provided with either a first movement-regulating portion for regulating the moving range of said movable body in said second direction or a second movement-regulating portion for regulating the moving range of said movable body in said third direction, or both.

18. The actuator as set forth in Claim 17 wherein said movable body is configured by joining a first holding member which holds said first magnets and a second holding member which holds said second magnets;
said first movement-regulating portion and said second movement-regulating portion abut on said movable body at positions different from a joint portion of said first holding member and said second holding member.

19. The actuator as set forth in any one of Claims 1 through 18 wherein, when said connecting body moves relative to said supporting body in said second direction and said third direction, said connecting body is deformed in the direction which perpendicularly intersects with the stretching direction of said connecting body, according to the deformation property of the shear direction in which a linear component is greater than a non-linear component.

20. The actuator as set forth in any one of Claims 1 through 18 wherein
said connecting body connects said movable body with said supporting body at the position in which said movable body and said supporting body are opposed in said first direction; and
when said movable body approaches said supporting body in said first direction, said movable body is compressed according to the stretching property in which the non-linear component is greater than the linear component.
